(19) Europäisches Patentamt
European Patent Office
Office européen des brevets

(11) **EP 1 826 906 A2**

(12) **EUROPEAN PATENT APPLICATION**

(43) Date of publication:
**29.08.2007 Bulletin 2007/35**

(51) Int Cl.:
**H03M 1/10** (2006.01)

(21) Application number: **07001033.5**

(22) Date of filing: **18.01.2007**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **28.02.2006 JP 2006053049**
**14.11.2006 JP 2006307317**

(71) Applicant: **HITACHI, LTD.**
**Chiyoda-ku**
**Tokyo 100-8280 (JP)**

(72) Inventors:
• **Kanekawa, Nobuyasu,**
**c/o Hitachi Ltd.,**
**IP Group**
**Chiyoda-ku**
**Tokyo 100-8220 (JP)**

• **Sasaki, Shoji,**
**c/o Hitachi Ltd.,**
**IP Group**
**Chiyoda-ku**
**Tokyo 100-8220 (JP)**

• **Abe, Yoshitaka,**
**c/o Hitachi Ltd.,**
**IP Group**
**Chiyoda-ku**
**Tokyo 100-8220 (JP)**

(74) Representative: **Beetz & Partner**
**Steinsdorfstrasse 10**
**80538 München (DE)**

(54) **Resolver / digital-converter and control system using the resolver / digital-converter**

(57)     A resolver/digital-converter having a self-fault-detection function without breaking normal operation is provided. The resolver (11) digital-converter, which has a normal operation function section, a temperature characteristic identification function section (12), and a first temperature characteristic correction function section of correcting estimated angle output from the normal operation function section based on a temperature characteristic identification value by the temperature characteristic identification function section, includes a holding function section (630) of holding the temperature characteristic identification value, and (2) a second temperature characteristic correction function section of correcting estimated angle output from the temperature characteristic identification function section based on the temperature characteristic identification value by the temperature characteristic identification function section, the value being held in the holding function section.

FIG.4

EP 1 826 906 A2

**Description**

BACKGROUND OF THE INVENTION

FIELD OF THE INVENTION

The present invention relates to a resolver/digital-converter, and particularly relates to a fault detection function of the resolver/digital-converter.

DESCRIPTION OF RELATED ART

In a servo control system, a rotation angle sensor is necessary to detect a rotation angle and perform feedback control. In addition, in brushless motor control, since current application is necessary to a coil of a motor depending on a rotation angle of the motor, the rotation angle sensor is necessary also in the servo control system. As the rotation angle sensor, a resolver has been widely used due to robustness and environment resistance caused by a simple configuration thereof.

A resolver/digital-converter has been developed, which is for performing conversion into a rotation angle based on a signal from the resolver, and inputting it into a microcomputer or the like as digital data. The resolver/digital-converter is described, for example, JP-A-2000-353957, JP-A-2005-348208, JP-A-9-126809, JP-A-7-131972, JP-A-9-133718 or JP-A-2005-3530.

SUMMARY OF THE INVENTION

For a method according to the above prior arts, further consideration is required in the light of fault detection. Motor output torque τm of a DC brushless motor is typically expressed by the following equation.

$$\tau m = K \bullet iq \bullet cos\theta e \qquad\qquad (1)$$

However, τm is motor output torque, K is torque constant, iq is q-axis current, and θe is magnetic-pole-position measurement error.

It is known from the equation that the motor output torque τm significantly depends on the magnetic-pole-position measurement error θe. In particular, when θe is larger than 90° or smaller than -90°, a value of cosθe is negative. That is, a sign of the q-axis current iq is opposite to a sign of the motor output torque τm, and when a motor is tried to be rotated clockwise, it is rotated counterclockwise, and conversely when the motor is tried to be rotated counterclockwise, it is rotated clockwise, and consequently the motor is rotated in a direction opposite to an intended direction. Since a control system often has a feedback loop, while a value of cosθe is positive, variation in motor output torque τm due to the magnetic-pole-position measurement error θe can be compensated by negative feedback. However, in the case that polarity is inverted in this way, the negative feedback is changed to positive feedback, and consequently operation of the feedback loop is diverged. In particular, in a brushless motor used for applications such as electric power steering, when increase in magnetic-pole-position measurement error θe occurs as described above due to a fault in resolver or the like, a dangerous situation may be caused. Therefore, fault detection in resolver needs to be continuously carried out even while normal magnetic-pole-position detection operation is performed.

However, the prior arts do not take this issue into particular consideration. In the prior arts, fault detection needs to be performed in a way that a test signal for fault detection is inputted from an external circuit, and an output signal is measured. Therefore, there is a difficulty that the normal magnetic-pole-position detection operation needs to be stopped for fault detection.

Furthermore, when the prior arts are applied to an electric power steering system or the like, the normal magnetic-pole-position detection operation can not be stopped during operation of the relevant system. Therefore, there is a difficulty that fault detection is performed only immediately after power-on, or at start of operation in power-off, or at the end of operation in most cases, and consequently fault detection is hardly performed in realtime.

Therefore, an object of the invention is to provide a resolver/ digital-converter having a self-fault-detection function without breaking the normal magnetic-pole-position detection operation.

A resolver/ digital-converter of the invention includes a normal operation function section of calculating angle information based on a signal from a resolver, a temperature characteristic identification function section of calculating a correction value for correcting a temperature characteristic of the angle information based on a signal from the resolver, a fault detection unit of examining the normal operation function section or the temperature characteristic identification function section, and a holding function section of holding the correction value, wherein when the normal operation function section is examined, the angle information is calculated using the temperature characteristic identification function section, and the relevant calculated value is corrected by the correction value held in the holding function section.

Advantage of the Invention

According to the invention, fault detection of the resolver/digital-converter can be performed without breaking the normal magnetic-pole-position detection operation.

BRIEF DESCRIPTION OF THE DRAWINGS

Fig. 1 is a view showing an example for temperature characteristic correction;
Fig. 2 is a view showing operation of each section in the example of Fig. 1;
Figs. 3A to 3B are views showing examples of a resolver;
Fig. 4 is a view showing an example for self-checking;
Fig. 5 is a view showing of operation of each section in the example of Fig. 4;
Fig. 6 is a view showing an example of a test pattern and an expected value;
Fig. 7 is a view showing an example where the example of Fig. 1 is made in a self-checking type;
Fig. 8 is a view showing operation of each section in the example of Fig. 7;
Fig. 9 is a view showing an example of a test control function section;
Fig. 10 is a view showing an example of setting information;
Fig. 11 is a view showing an example of test operation shown in a time sequential manner;
Fig. 12 is a view showing an example of time-sequential mode change in test operation;
Fig. 13 is a view showing an example where selectors are placed in stages previous to a phase shift circuit and an addition/subtraction function section;
Fig. 14 is a view showing operation of each section in the example of Fig. 12;
Fig. 15 is a view showing an example where selectors are placed in stages previous to separately provided, phase shift circuits and addition/subtraction function sections;
Fig. 16 is a view showing operation of each section in the example of Fig. 14;
Fig. 17 is a view showing an example for making a method of the literature 2 to be in a self-checking type;
Fig. 18 is a view showing operation of each section in the example of Fig. 16;
Fig. 19 is a view showing an example where selectors are placed in stages previous to a phase shift circuit and an addition/subtraction function section;
Fig. 20 is a view showing operation of each section in the example of Fig. 18;
Fig. 21 is a view showing an example where selectors are placed in stages previous to separately provided, phase shift circuits and addition/subtraction function sections;
Fig. 22 is a view showing operation of each section in the example of Fig. 20;
Fig. 23 is a view showing an example for detecting a phase short fault;
Fig. 24 is a view showing operation of each section in the example of Fig. 22;
Fig. 25 is a view showing phases of signals in the example of Fig. 22;
Figs. 26A to 26B are views of resolvers for the example of Fig. 22;
Fig. 27 is a view showing an example for making the example of Fig. 22 to be in a self-checking type;
Fig. 28 is a view showing operation of each section in the example of Fig. 26;
Fig. 29 is a view showing an example where a phase-short-fault detection function is added to the example of Fig. 26;
Fig. 30 is a view showing operation of each section in the example of Fig. 28;
Fig. 31 is a view showing an example of a motor controller and a system being applied with the invention;
Fig. 32 is a view showing an example of a motor controller and a system being applied with the invention;
Fig. 33 is a view showing an example of a test result 657;
Fig. 34 is a view showing an example of a test result 657;
Fig. 35 is a view showing an example of a test result 657;
Fig. 36 is a view showing an example of an electric power steering being applied with the invention;
Fig. 37 is a view showing an example of an embodiment of the invention;
Fig. 38 is a view showing an example of an embodiment of the invention;
Fig. 39 is a view showing an example of temperature characteristic correction by feedback;
Fig. 40 is a view showing an example for making the example of Fig. 39 to be in a self-checking type;
Fig. 41 is a view showing an example of temperature characteristic correction by feedback; and

Fig. 42 is a view showing an example for making the example of Fig. 41 to be in a self-checking type.

DESCRIPTION OF THE PREFERRED EMBODIMENT

Hereinafter, examples of an embodiment of the invention are described according to drawings.

Example 1

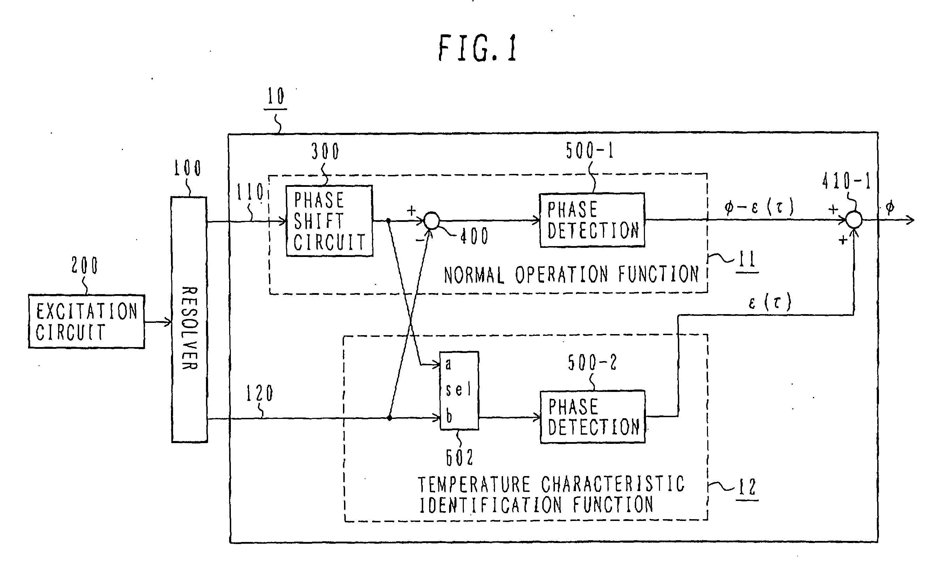

First, normal magnetic-pole-position detection operation being to be continuously performed is described using Figs. 1 to 3.
As shown in Fig. 1, a resolver/digital-converter not only converts an analog signal inputted from a resolver into a digital signal, but also corrects a temperature characteristic of the resolver. Therefore, both functions need to be continued. Hereinafter, each function is described.
A resolver 100 is excited by an excitation circuit 200, and outputs resolver output signals 110 and 120, and the signals are inputted into a resolver/digital-converter 10. An excitation signal from the excitation circuit 200 is expressed as $\sin(\omega t)$ (however, $\omega$ is angular velocity of the excitation signal, and t is time). The resolver outputs waveforms in which the excitation signal is modulated to have amplitude in proportion to values of a sine and a cosine of rotation angle (electrical angle) $\theta$ of the resolver. Here, when it is assumed that the resolver output signal 110 is a signal in proportion to the sine (sin signal), and the resolver output signal 120 is a signal in proportion to the cosine (cos signal), the resolver output signals 110 and 120 are expressed as follows respectively:

$$A \bullet \sin(\omega t + \varepsilon) \bullet \sin\theta, \qquad (2)$$

$$A \bullet \sin(\omega t + \varepsilon) \bullet \cos\theta. \qquad (3)$$

However, $\varepsilon$ is a signal delay characteristic due to the resolver and the circuit (hereinafter, abbreviated as "signal delay characteristic"), and A is a gain coefficient. Since the gain coefficient of the resolver and the signal delay characteristic have temperature dependence, when these are expressed as functions of temperature $\tau$, the followings are given:

$$A(\tau) \bullet \sin(\omega t + \varepsilon(\tau)) \bullet \sin\theta, \qquad (4)$$

$$A(\tau) \bullet \sin(\omega t + \varepsilon(\tau)) \bullet \cos\theta. \qquad (5)$$

In the coefficients having temperature dependence, $A(\tau)$ can be cancelled by using a ratio between the resolver output signals 110 and 120, and $\varepsilon(\tau)$, the temperature characteristic of which must be considered in a method of calculating a rotation angle of the resolver focusing a phase of the resolver output signal, can by cancelled by the following method.
The resolver/digital-converter 10 includes a normal operation function section 11 including a phase shift circuit 300, an addition/subtraction function section 400, and a phase detection circuit 500-1; a temperature characteristic identification function section 12 including a selector 602 and a phase detection circuit 500-2; and a temperature characteristic correction function section 410-1.
In the normal operation function section 11, the inputted resolver output signal (sin signal) 110 is shifted in phase by the phase shift circuit 300, and the inputted resolver output signal (cos signal) 120 is subtracted in the addition/subtraction function section 400.
Here, when the resolver output signal (sin signal) 110 is shifted in phase by 90 degrees by the phase shift circuit 300, it is expressed by $A(\tau) \bullet \cos(\omega t + \varepsilon(\tau)) \bullet \sin\theta$. When the resolver output signal 120 is subtracted, the following signal is given:

$$A(\tau)\bullet\cos(\omega t+\varepsilon(\tau))\bullet\sin\theta-A(\tau)\bullet\sin(\omega t+\varepsilon(\tau))\bullet\cos\theta$$

$$=A(\tau)\bullet\sin\{\theta-(\omega t+\varepsilon(\tau))\}.$$

The signal having been subjected to subtraction is inputted into the phase detection circuit 500-1 so that phase difference with respect to the excitation signal $\sin(\omega t)$ is obtained. Thus obtained value corresponds to an estimated angle output $(\phi)-\varepsilon(\tau))$ ($\phi$ is an estimated value of $\theta$).

In the temperature characteristic identification function section 12, one of the resolver output signals 110 and 120 is selected by a selector 602, and inputted into the phase detection circuit 500-2. Since the resolver output signals 110 and 120 are as described in expressions (4) and (5) respectively, operation of obtaining phase difference with respect to the excitation signal $\sin(\omega t)$ in the phase detection circuit 500-2 corresponds to operation of obtaining the signal delay characteristic $\varepsilon(\tau)$.

However, positive and negative may be inverted depending on a value of $\sin\theta$ or $\cos\theta$. To avoid influence of this, the resolver output signals 110 and 120 can be treated as absolute values:

$$|A(\tau)\bullet\sin(\omega t+\varepsilon(\tau))\bullet\sin\theta| \text{ and } |A(\tau)\bullet\sin(\omega t+\varepsilon(\tau))\bullet\cos\theta|.$$

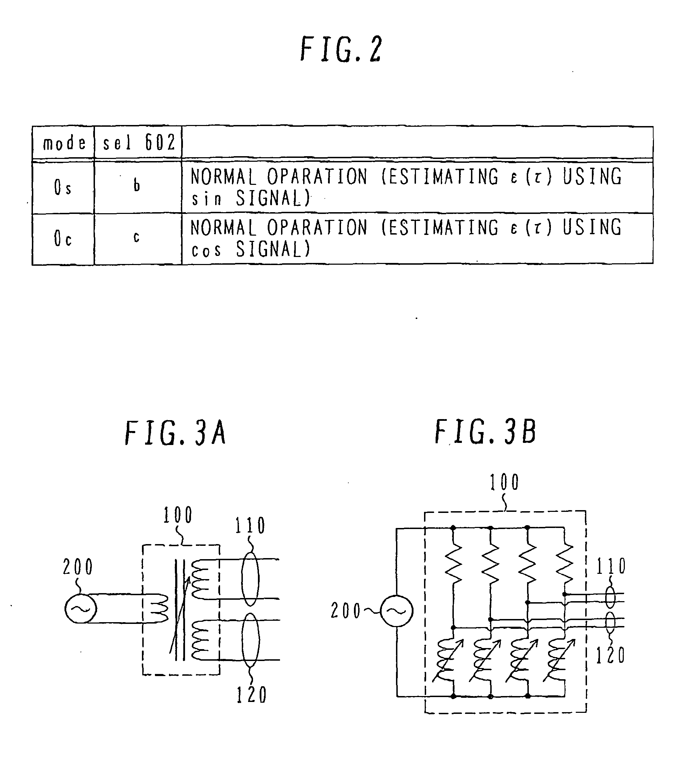

Alternatively, $\varepsilon$ can be treated in a form of an absolute value, that is, $|\varepsilon(\tau)|$. As shown in Fig. 2, when input a is selected in the selector 602, the signal delay characteristic $\varepsilon(\tau)$ is estimated using the resolver output signal (sin signal) 110 (mode Os), and when input b is selected, the signal delay characteristic $\varepsilon(\tau)$ is estimated using the resolver output signal (cos signal) 120 (mode 0c). In the light of improving measurement accuracy by increasing a signal to noise ratio, it is enough that the selector 602 selects a signal having a larger amplitude between the resolver output signals 110 and 120. In this way, the temperature characteristic identification function section 12 can obtain the signal delay characteristic $\varepsilon(\tau)$.

When the estimated angle output $(\phi)-\varepsilon(\tau))$ obtained in the normal operation function section 11 in the above-described way is added with $\varepsilon(\tau)$ which is obtained in the temperature characteristic identification function section 12 in the temperature characteristic correction function section 410-1, estimated angle output $\phi$ having been subjected to temperature characteristic correction can be obtained.

The phase detection circuits 500-1 and 500-2 may be achieved in various methods, and for example, there are a method that zero crossing of a signal is detected by a counter as in JP-A-9-126809, and a method that a phase of a reference signal is allowed to follow an input signal based on a correlation function value between the input signal and the reference signal as shown in JP-A-2005-207960 that was previously filed by the inventors. The invention can be applied to either of the methods, and can provide an advantage in each method.

Methods of configuring various sections of the resolver/digital-converter 10 include a method of achieving them by an analog circuit, method of achieving them by a digital circuit, and method of achieving them by mixing the analog and digital circuits. The invention can be applied to any of the methods, and can provide an advantage in each method. Furthermore, in the method of achieving them by mixing the analog and digital circuits, various ways may be considered for selecting each portion to be achieved by the analog or digital circuit, and therefore an analog/digital-converter is provided between the analog and digital circuits.

Fig. 3 shows an example of the resolver 100 used in the example of Fig. 1. The resolver 100 can be roughly classified into a type where the resolver output signals 110, 120 are induced in a different secondary winding from a secondary winding for an excitation signal as shown in Fig. 3A, and a type where a common winding is provided for the excitation signal and the resolver output signals 110, 120 as shown in Fig. 3B. In the type as shown in Fig. 3A, coupling between the excitation signal applied to a primary winding and the secondary winding in which the resolver output signals 110, 120 are induced is changed with a rotation angle $\theta$ of a core, and amplitudes of the induced resolver output signals 110, 120 are accordingly changed. In the type as shown in Fig. 3B, inductance of the common winding for the excitation signal and the resolver output signals 110, 120 is changed with the rotation angle $\theta$ of the core, and amplitudes of the resolver output signals 110, 120 are changed, the amplitudes being obtained by dividing the excitation signal.

Next, description is made on an example of fault detection without breaking magnetic-pole-position detection operation as described above in which influence of the temperature characteristic is corrected.

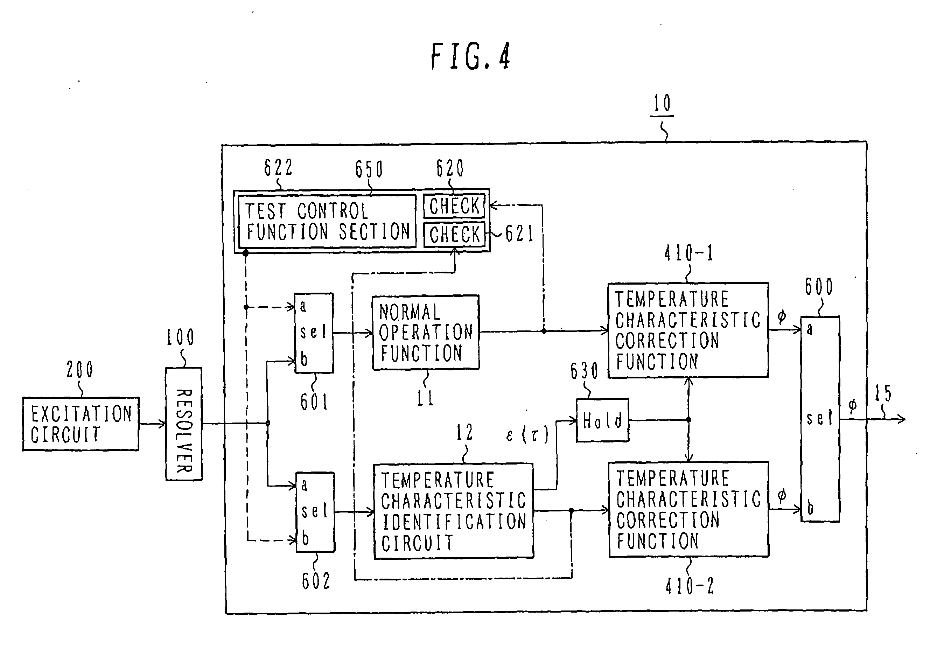

Fig. 4 shows an example for achieving a fault detection function during operation, that is, an online test function or online fault detection function. The online test is a test for fault detection to be performed during normal operation, in which part of the inside of a circuit is tested (examined) while obtaining output equal to output in normal operation. Although it is a test of part of the inside of the circuit, a circuit portion to be a test object is changed depending on a mode as an embodiment of the invention, thereby increased number of circuit portions can be made as an examination object. On the other hand, an offline test is a test for fault detection that is performed with normal operation being stopped. Compared with a configuration shown in Fig. 1, there is a difference in that it has a fault detection unit 622, input selectors 601 and 602, an output selector 6, and a holding function section 630. Details of the normal operation function section 11 and the temperature characteristic identification function section 12 are as shown in Fig. 1 or examples described later, and omitted to be described here. The fault detection unit 622 controls switching between the input selectors 601 and 602. Thus, one of a resolver output signal (a) and a test signal (b) (test pattern) outputted by the fault detection unit 622 is selected to be inputted into the normal operation function section 11 or the temperature characteristic identification function section 12. Moreover, the fault detection unit 622 controls the holding function section 630. Thus, whether the temperature characteristic is corrected based on data outputted by the temperature characteristic identification function section 12, or corrected based on the held, previous data is selected. Hereinafter, the operation is described in detail.

The resolver 100 is excited by the excitation circuit 200, and outputs the resolver output signals 110 and 120 which are then inputted into the resolver/digital-converter 10. The resolver output signals 110 and 120 are inputted into the normal operation function section 11 and the temperature characteristic identification function section 12 via the input selectors 601 and 602. The temperature characteristic identification function section 12 estimates the signal delay characteristic $\varepsilon(\tau)$ of the resolver output signals 110 and 120, which include temperature characteristics, and outputs them to the holding circuit 603. Output of the normal operation function section 11, that is, estimated angle output is corrected based on the signal delay characteristic $\varepsilon(\tau)$ in the temperature characteristic correction function section 410-1, thereby to become a corrected, estimated angle output $\phi$. Similarly, estimated angle output outputted by the temperature characteristic identification function section 12 is corrected based on the signal delay characteristic $\varepsilon(\tau)$ in the temperature characteristic correction function section 410-2, thereby to become a corrected, estimated angle output $\phi$.

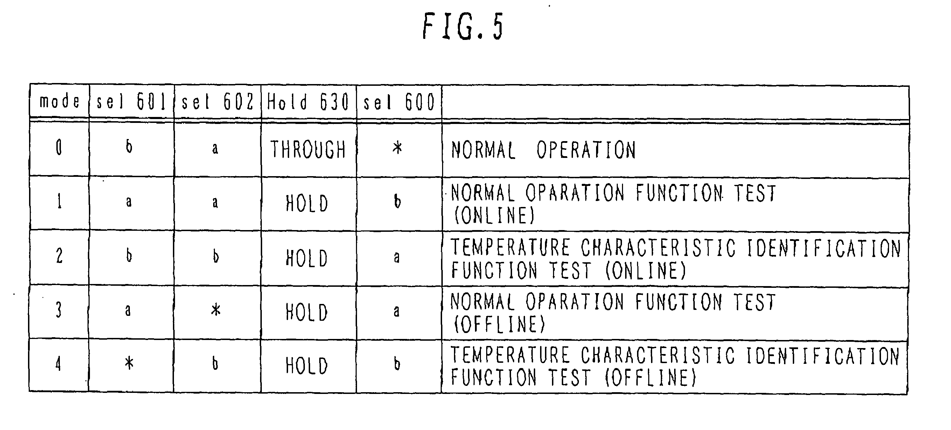

Fig. 5 shows operation modes in detail. The resolver/digital-converter in the example has a plurality of operation modes depending on switching of each of the input selectors 601, 602 and the output selector 600, and HOLD/THROUGH in the holding function section 630. Hereinafter, each operation mode is described.

(Mode 0) At timing when fault detection is not performed (during normal operation), the selectors 601 and 602 select resolver output signals 110 and 120 respectively as shown in mode 0 of Fig. 5, and the holding function section 630 operates to output the inputted signal as it is without performing holding operation.

(Mode 1) In the case that the normal operation function section 11 is examined for fault detection, as shown in mode 1 of Fig. 5, the selector 601 is switched, so that a test pattern is inputted from the fault detection unit 622, and output of the normal operation function section 11 is inputted into the fault detection unit 622. A check function section 620 of the fault detection unit 622 checks whether the inputted output of the normal operation function section 11 corresponds to an expected value corresponding to the inputted test pattern. When the output of the normal operation function section 11 corresponds to the expected value, the normal operation function section 11 is determined to be normal. The term "correspond" mentioned herein does not imply physical identicalness, and implies that difference between the output and the expected value is within a certain range of a substantially unproblematic level in the light of use of the relevant resolver/digital-converter.

In this state, since output of the normal operation function section 11 is corresponding to input of the test pattern, it is not corresponding to the resolver output signal. Therefore, output of the normal operation function section 11 can not be used as final output 15. Thus, as shown in Fig. 5 (mode 1), the output selector 600 is switched such that it outputs corrected, estimated angle output $\phi$ based on estimated angle output of the temperature characteristic identification function section 12 can be output. That is, output of the temperature characteristic correction function section 410-2 is selected as the final output 15. By adopting such configuration, the normal operation function section 11 can be examined without breaking the magnetic-pole-position detection.

At that time, since the temperature characteristic identification function section 12 is used in place of the normal operation function section 11, the signal delay characteristic $\varepsilon(\tau)$ is sometimes not obtained. In the case that the signal delay characteristic $\varepsilon(\tau)$ is not obtained, an estimated angle value being not having been subjected to temperature characteristic correction becomes the final output 15. Thus, as shown in Fig. 5 (mode 1), a signal delay characteristic $\varepsilon(\tau)$ in an operation period at a previous time or before can be held in the holding function section 630 to be used. In general, since operation temperature is not suddenly changed, in a typically used, online test period of the temperature characteristic identification function section 12, there is substantially no problem even if the held data are used for correction. Thus, the normal operation function section 11 can be examined without breaking the magnetic-pole-position detection having been subjected to temperature characteristic correction.

(Mode 3) In the case that the normal operation function section 11 is examined for fault detection offline such as a case immediately after power-on, as shown in mode 3 of Fig. 5, the selector 600 selects output of the temperature characteristic correction function section 410-1 as the final output 15. At that time, the final output 15 of the resolver/digital-converter 10 is checked by a not-shown microprocessing unit 20 being connected to the resolver/digital-converter 10, in addition to the check function section 620. In this case, the temperature characteristic correction function section 410-1 and the selector 600 can be examined in addition to the normal operation function section 11.

(Mode 2) In the case that the temperature characteristic identification function section 12 is examined for fault detection, as shown in Fig. 5, the selector 600 is switched so that a test pattern is inputted from the fault detection unit, and output of the temperature characteristic identification function section 12 is inputted into the fault detection unit 622. A check function section 621 of the fault detection unit 622 checks whether the inputted output of the temperature characteristic identification function section 12 corresponds to an expected value corresponding to the inputted test pattern. When the output of the temperature characteristic identification function section 12 corresponds to the expected value, the temperature characteristic identification function section 12 is determined to be normal. Meaning of the term "correspond" is the same as in the mode 1.

In this state, since the input selector 601 is set such that it inputs the resolver output signal, input into the normal operation function section 11 is corresponding to the resolver output signal. Thus, at that time, the output selector 600 is set such that it outputs the corrected, estimated angle output $\phi$ based on the estimated angle output of the normal operation function section 11 (a) as shown in Fig. 5. That is, output of the temperature characteristic correction function section 410-1 can be selected as the final output 15.

In this state, since output of the temperature characteristic identification function section 12 is corresponding to input of the test pattern, it is not corresponding to the resolver output signal. Therefore, a signal delay characteristic $\varepsilon(\tau)$ outputted from the temperature characteristic identification function section 12 can not be obtained. In the case that the signal delay characteristic $\varepsilon(\tau)$ is not obtained, an estimated angle value not having been subjected to the temperature characteristic correction becomes the final output 15. Thus, as shown in Fig. 5 (mode 2), a signal delay characteristic $\varepsilon(\tau)$ in an operation period at a previous time or before can be held in the holding function section 630 to be used. Thus, the temperature characteristic identification function section 12 can be examined without breaking the magnetic-pole-position detection having been subjected to temperature characteristic correction.

(Mode 4) In the case that the temperature characteristic identification function section 12 is examined for fault detection offline such as a case immediately after power-on, as shown in Fig. 5 (mode 4), the selector 600 can select output of the temperature characteristic correction function section 410-2 as the final output 15. At that time, the final output 15 of the resolver/digital-converter 10 is checked by the not-shown microprocessing unit 20 being connected to the resolver/digital-converter 10, in addition to the check function section 621. In this case, the temperature characteristic correction function section 410-2 and the selector 600 can be examined in addition to the temperature characteristic identification function section 12.

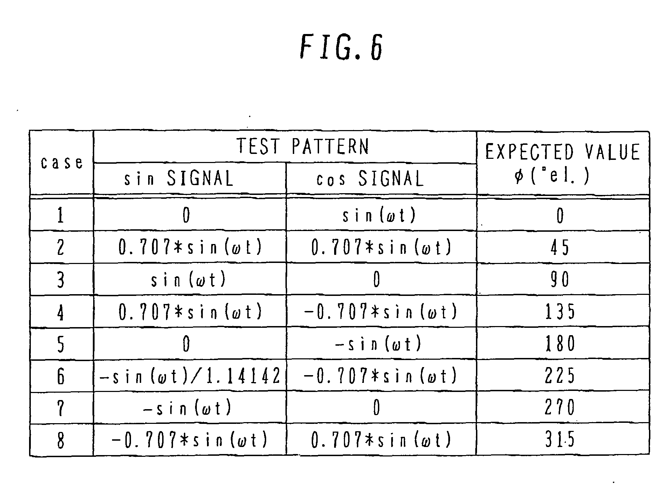

Fig. 6 shows an example of a test patter for fault detection. As shown in the figure, when a signal, in which an excitation signal sin ($\omega$t) is multiplied by amplitude coefficients of $\pm$1.0, $\pm$SQRT(2)/2 or $\pm$0.707, and 0, is inputted, a test can be carried out on an expected value at every 45 degrees. Moreover, when distortion in signal due to variation in level may not occur, the amplitude coefficient $\pm$0.707 can be assumed as $\pm$1, and consequently a circuit for producing a test pattern can be simplified.

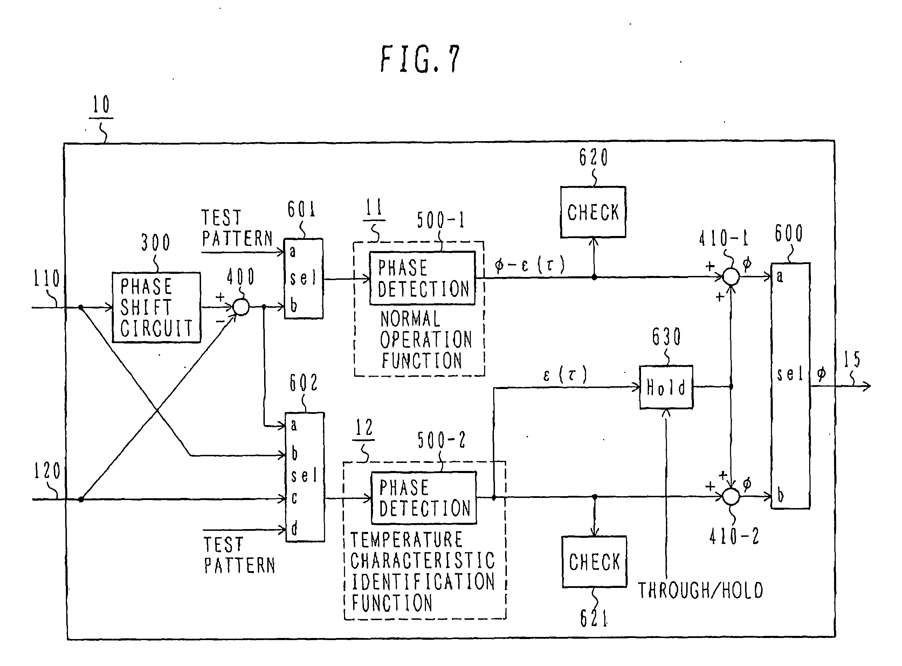

Fig. 7 shows an example in the case that a configuration as shown in Fig. 4 is specifically implemented. While the fault detection unit 622 is omitted for simplification, and only input of the test pattern and the check function sections 620 and 621 are shown in Fig. 7, operation of the unit is the same as in Fig. 4. In addition, configurations and functions being not particularly described are the same as in the example shown in Fig. 4 or Fig. 1.

Similarly as in the example shown in Fig. 4, in the normal operation function section 11, the inputted resolver output signal (sin signal) 110 is shifted in phase by the phase shift circuit 300, and the inputted resolver output signal (cos signal) 120 in the addition/subtraction function section 400 is subtracted. The signal after subtraction is inputted into the phase detection circuit 500-1 so that phase difference with respect to the excitation signal sin($\omega$t) is obtained. Thus obtained value corresponds to an estimated angle output ($\phi$-$\varepsilon(\tau)$).

In the temperature characteristic identification function section 12, one of the resolver output signals 110 and 120 is selected by a selector 602, and inputted into the phase detection circuit 500-2 so that phase difference with respect to the excitation signal sin($\omega$t), that is, the signal delay characteristic $\varepsilon(\tau)$ is obtained. The signal delay characteristic $\varepsilon(\tau)$ is outputted to the holding circuit 603. Output of the normal operation function section 11, that is, estimated angle output is corrected based on the signal delay characteristic $\varepsilon(\tau)$ in the temperature characteristic correction function section 410-1, thereby to become a corrected, estimated angle output $\phi$. Similarly, estimated angle output outputted by the temperature characteristic identification function section 12 is corrected based on the signal delay characteristic $\varepsilon(\tau)$ in the temperature characteristic correction function section 410-2, thereby to become a corrected, estimated angle output $\phi$.

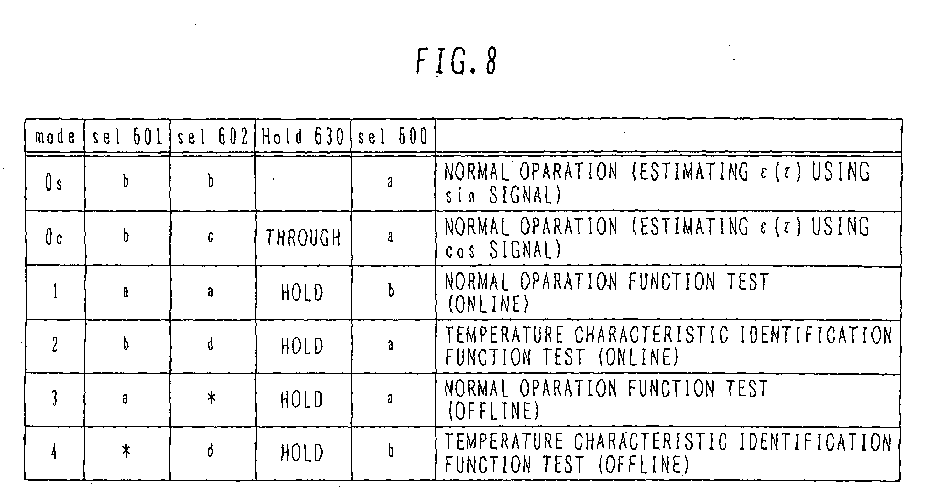

(Mode 0s, 0c) As shown in Fig. 8, at timing when examination is not performed (during normal operation), the input selector 601 selects input from the resolver (b). The reason why there are two modes is that there are two cases, that is, a case that the signal delay characteristic $\varepsilon(\tau)$ is obtained based on the resolver output signal (sin signal) 110 (mode 0s), and a case that it is obtained based on the resolver output signal (cos signal) 120 (mode 0c), as in Fig. 1. Input from the resolver into the input selector 601 is a signal obtained by shifting the phase of the resolver output signal (sin signal) 110 by the phase shift circuit 300 and subtracting the resolver output signal (cos signal) 120. The relevant subtraction is performed in the addition/subtraction function section 400. The signal selected by the selector 601 is inputted into the phase detection circuit 500-1 so that phase difference with respect to the excitation signal sin($\omega$t) is

obtained. Thus obtained value corresponds to the estimated angle output $(\phi)-\varepsilon(\tau)$.

At the timing when examination is not performed (during normal operation), the input selector 602 selects a resolver output signal. While there are a resolver output signal (sin signal) 110 (b) and a resolver output signal (cos signal) 120 (c) as the resolver output signal, either of them may be selected. The signal selected by the input selector 602 is inputted into the phase detection circuit 500-2 so that phase difference with respect to the excitation signal sin $(\omega t)$, that is, the signal delay characteristic $\varepsilon(\tau)$ is obtained. The signal delay characteristic is used to correct estimated angle output. While the signal delay characteristic $\varepsilon(\tau)$ can be calculated using either of the sin signal 110 and the cos signal 120 of the resolver output signals, a mode can be determined such that a signal having a larger amplitude is selected between the resolver output signals 110 and 120 from the viewpoint of improving measurement accuracy by increasing a signal to noise ratio.

In the mode 0s or 0c, the holding function section 630 operates to output the input signal as it is without performing holding operation. Furthermore, the output selector 600 selects output of the temperature characteristic correction function 410-1 as the final output 15.

The example is for describing detail of the normal operation function section 11 and the temperature characteristic operation function section 12, wherein operation in the online test (mode 1) and offline test (mode 3) of the normal operation function section 11, and the online test (mode 2) and offline test (mode 4) of the temperature characteristic operation function section 12 are the same as in the example shown in Fig. 4 and Fig. 5. However, in the example, since the input selector 602 is in a 4-input configuration, test pattern input is (d).

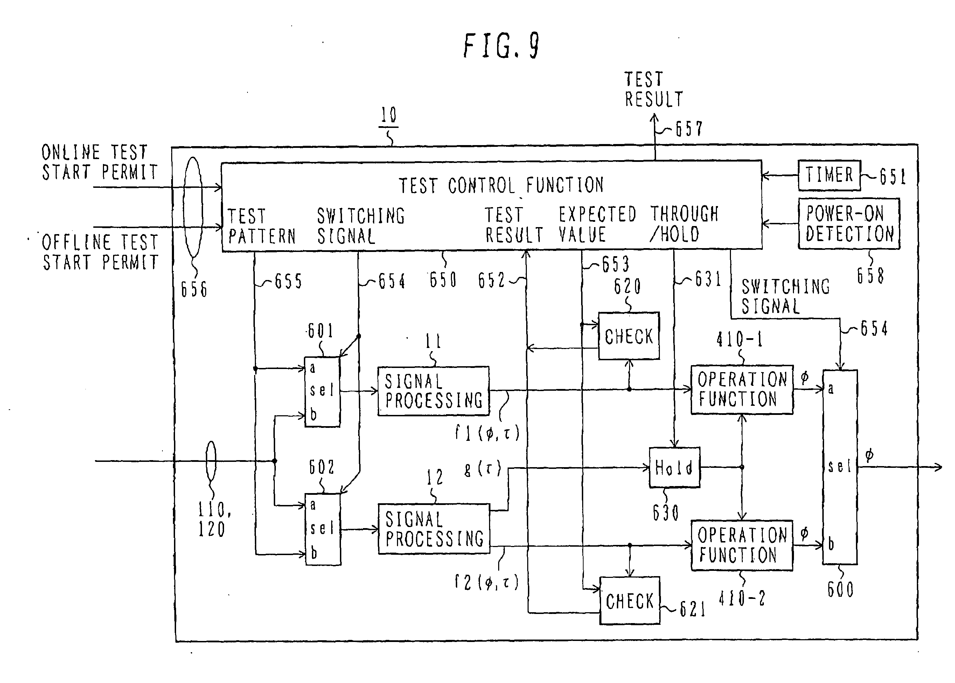

Fig. 9 shows an example of a test function control section 650. The test function control section 650 is provided in the fault detection unit 622, and operates according to setting information 656 inputted from the outside. The setting information 656 includes online test start information, online test start permit information, offline test start information, and offline test start permit information. The test function control section 650 outputs the test pattern as shown in Fig. 6 to selectors 601 to 606, outputs a switching signal to selectors 600 to 607, outputs a control signal (THROUGH/HOLD) 631 on whether a signal is held or not to the holding function section 630, outputs an expected value 653 corresponding to a test pattern to the check function sections 620 and 621, or receives test results 652 from the check function sections 620 and 621.

Furthermore, the section 650 outputs a test result 657 to the microprocessing unit 20 based on the test results 652 from the check function sections 620 and 621. When both the test results 652 from the check function sections 620 and 621 are normal, it outputs a signal indicating a normal condition as the test result 657, and when even one of the test results 652 from the check function sections 620 and 621 shows an abnormal condition, it outputs a signal indicating an abnormal condition as the test result 657 to the outside.

Desirably, the online test is automatically performed at a certain interval with a period being set by a timer 651. Thus, fault detection of the resolver can be continuously performed even while the normal magnetic-pole-position detection is operated. Moreover, when a signal from a power-on detection circuit 658 is used, the offline test immediately after power-on can be performed in an automatically started manner. While the check function sections 620 and 621 may be configured to be provided within the fault detection unit 622 as shown in Fig. 2, it may be configured as a different unit from the fault detection unit 622, and configured to transmit an expected value corresponding to a test pattern from the fault detection unit 622. When the check function sections 620 and 621 are provided separately from the fault detection unit 622, the fault detection unit 622 is equivalent to the test function control section 650 as shown in Fig. 9.

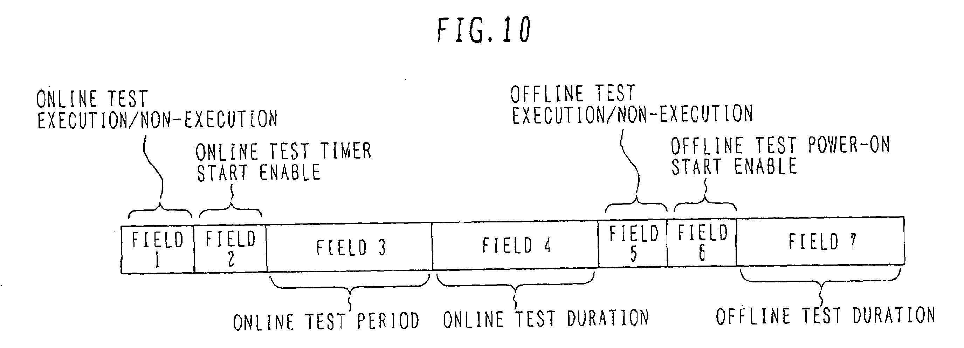

Fig. 10 shows an example of the setting information 656. The setting information 656 can be set by writing it into a register, or by making each signal terminal be at a certain level.

Field 1 is a field for determining whether the online test is executed or not. An example of setting values and functions of them is shown below.

00 (binary number): normal operation mode in which the online test is not executed.
01 (binary number) : online test of the normal operation function section is executed.
10 (binary number) : online test of the temperature characteristic identification function section is executed.

Field 2 is a field for determining whether execution of the online test is enabled by the timer 651 or not.

00 (binary number) : online test is not started by the timer 651.
01 (binary number) : online test of the normal operation function section is started by the timer 651.
10 (binary number) : online test of the temperature characteristic identification function section is started by the timer 651.
11 (binary number) : online tests of the normal operation function section and the temperature characteristic identification function section are alternately started by the timer 651.

Field 3 shows a period at which the online test is started by the timer 651, wherein a unit is defined by realtime or count values of the timer. Field 4 shows duration time after starting the online test, wherein a unit is defined by realtime or count values of the timer as well.

Field 5 is a field for determining whether the offline test is executed or not. An example of setting values and functions of them is shown below.

00 (binary number): normal operation mode in which the offline test is not executed.
01 (binary number) : offline test of the normal operation function section is executed.
10 (binary number): offline test of the temperature characteristic identification function section is executed.

Field 6 is a field for determining whether the offline test is executed by power-on or not.

00 (binary number): offline test is not started by power-on.
01 (binary number) : offline test of the normal operation function section is started by power-on.
10 (binary number): offline test of the temperature characteristic identification function section is started by power-on.
11 (binary number): offline tests of the normal operation function section and the temperature characteristic identification function section are started by power-on.

Field 7 shows duration time after starting the offline test by power-on, wherein a unit is defined by realtime or count values of the timer as well.

In particular, since the fields 6 and 7 determine operation immediately after power-on, they can be set by using a register including a non-volatile memory in which data are not erased even if power is off, or a mode setting terminal.

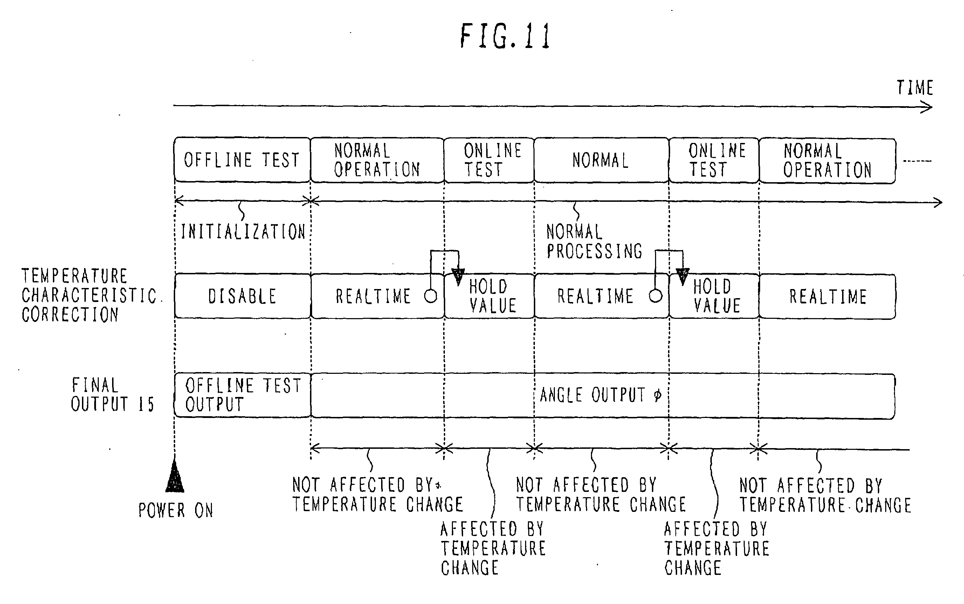

Fig. 11 shows test operation in a time sequential manner. The offline test is performed for initialization immediately after power-on, and then it is shifted to normal processing after the offline test is finished. In the normal processing, the online test is performed during the normal magnetic-pole-position detection operation. A trigger for starting the online test can be inputted from the outside, for example, the microprocessor 20, or can be generated in the timer 651 as described before. Also, the offline test can be performed before power is turned off after the normal processing is finished.

While the offline test is performed, the temperature characteristic correction can not be performed, and offline test output is outputted as the final output 15 as well. When the offline test is completed, and processing is shifted to the normal processing, an angular signal $\phi$ is outputted as the final output 15. During normal operation, the temperature characteristic can be corrected in realtime without being affected by temperature change.

Since during the online test the temperature characteristic correction is performed based on a held value of a signal delay characteristic $\varepsilon(\tau)$ obtained immediately before the test, when temperature change occurs in this period, influence of the temperature change can not be corrected. Thus, in consideration of a level of change in temperature in the environment where the relevant resolver is typically used, an operation interval of the online test is set such that an error associated with calculation of the angular signal using the held value of the signal delay characteristic $\varepsilon(\tau)$ is within an unproblematic range in the light of angle detection accuracy required for the resolver. Thus, since the correction is not substantially affected by the temperature change during the online test, the resolver/digital-converter can be examined without breaking the magnetic-pole-position detection having been subjected to temperature characteristic correction.

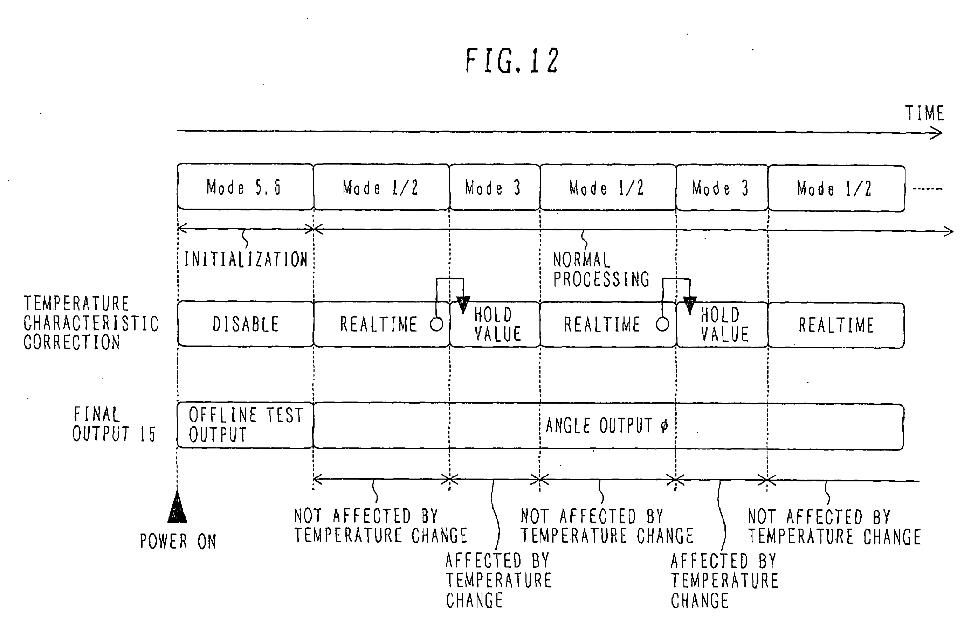

Furthermore, Fig. 12 shows time-sequential mode change in a series of test operations. The offline test is performed in operation as shown in a mode 3 or mode 4 for initialization immediately after power-on, and then it is shifted to normal processing after the offline test is finished. In the normal processing, the normal magnetic-pole-position detection operation is performed in setting as shown in the mode 0s or the mode 0c in most time, and during such operation, the online test is performed in operation of a mode 1 (normal mode function test) or a mode 2 (temperature characteristic identification function test) . During performing the online test, operation of the mode 2 (temperature characteristic identification function test) can be continuously performed subsequent to operation of the mode 1 (normal mode function test), or operation of the mode 3 (normal mode function test) and operation of the mode 4 (temperature characteristic identification function test) can be alternately repeated with the normal operation as shown in the mode 0s or the mode 0c between them, as shown in Fig. 12. The temperature correction operation and the contents of the final output 15 in each test stage are the same as in Fig. 11.

Example 2

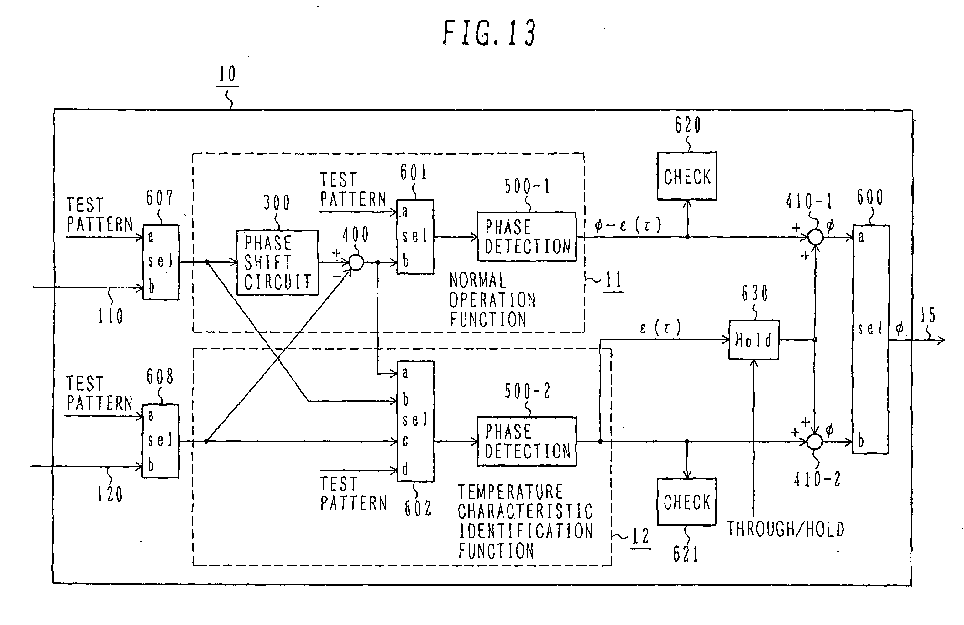

Fig. 13 shows a second example of an embodiment of the invention. Compared with the example 1, the example is different in that input selectors 607 and 608 for injecting a test pattern are placed in a stage previous to the phase shift circuit 300 and the addition/subtraction function section 400. Configurations being not particularly described are the same as in the example 1. According to the example, the phase shift circuit 300 and the addition/subtraction function section 400 can be made as objects of the offline test, so that fault in the phase shift circuit and the addition/subtraction function section can be also detected.

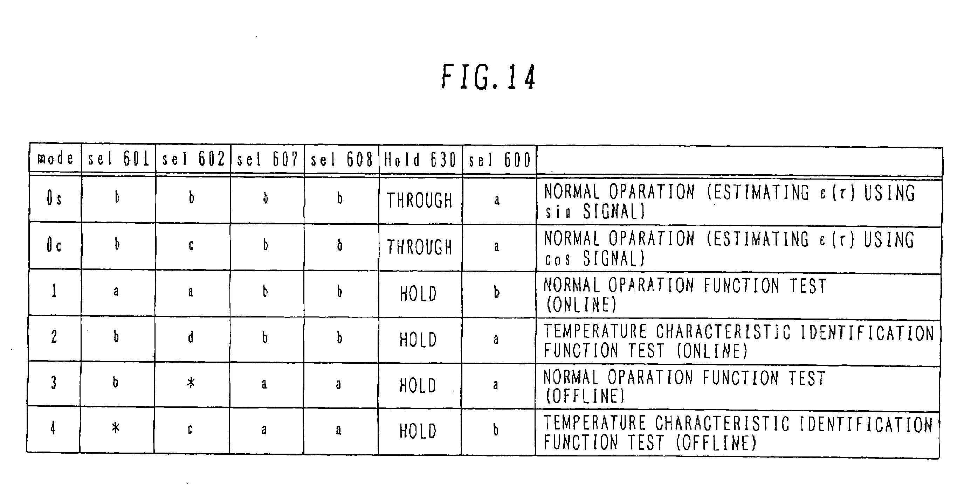

Operation of each selector in the example is shown in Fig. 14. Operation of the selectors 601 and 602 is the same as in the example 1 (Fig. 7 and Fig. 8) except for modes 3 and 4 for the offline test. As shown in Fig. 14, in the modes 3 and 4, the selectors 607 and 608 select a test pattern as input, so that the offline tests of the normal mode function section 11 and the temperature characteristic identification function section 12 are performed including the phase shift circuit and the addition/subtraction function section.

Example 3

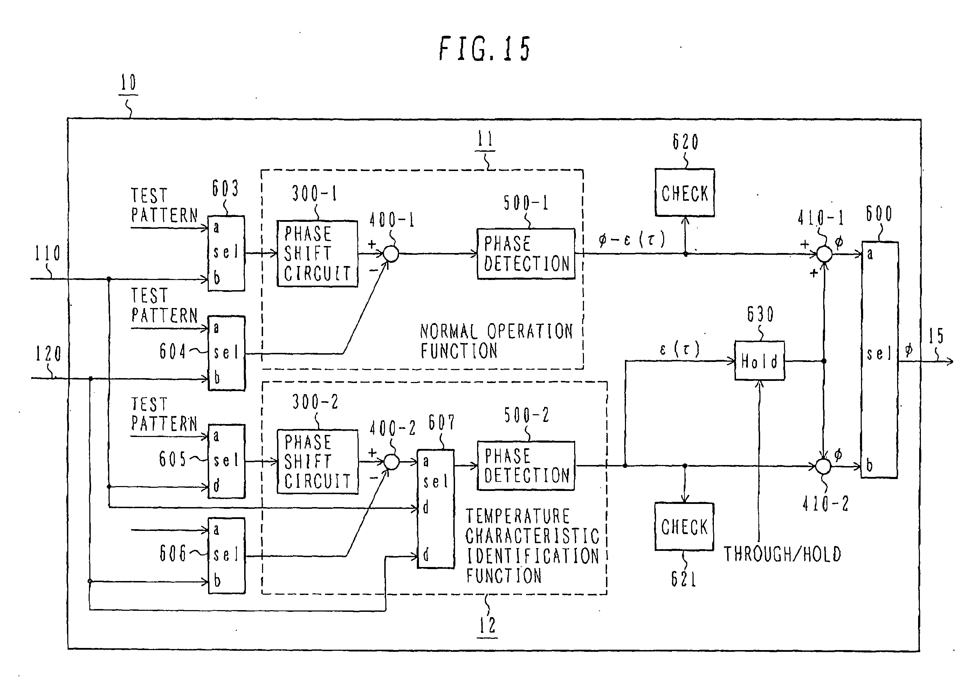

Fig. 15 shows a third example of an embodiment of the invention. Compared with the example 2, the example is different in that the normal mode function section 11 and the temperature characteristic identification function section 12 separately have phase shift circuits 300-1, 300-2 and addition/subtraction function sections 400-1, 400-2, and selectors 603 to 606 for injecting a test pattern are placed in a stage previous to the phase shift circuits 300-1, 300-2 and the addition/subtraction function sections 400-1, 400-2. According to the example, since the phase shift circuits and the addition/subtraction function sections can be also made as objects of the online test, faults can be detected without breaking the normal magnetic-pole-position detection operation including faults in the phase shift circuits and the addition/subtraction function sections.

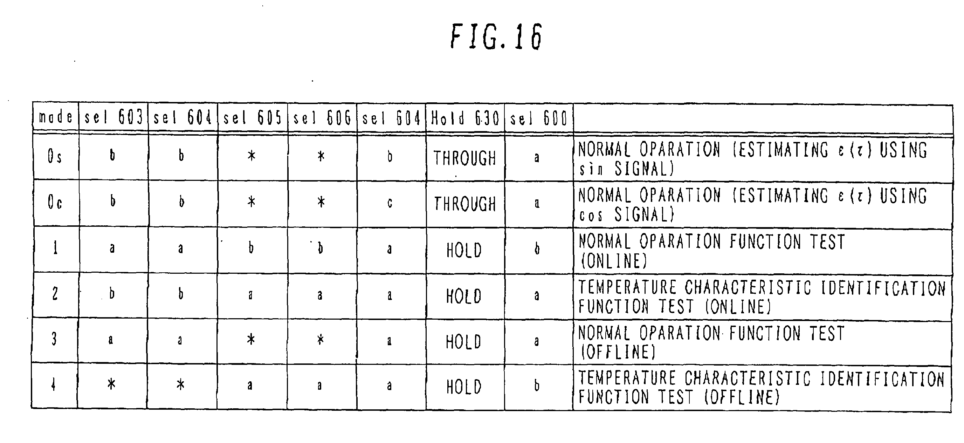

Operation of each selector in the example is shown in Fig. 16.

(Mode 0s, 0c) As shown in Fig. 16, at timing when examination is not performed (during normal operation), the selector 603 selects the resolver output signal (sin signal) 110 and inputs it into the phase shift circuit 300-1. At that time, the selector 604 selects the resolver output signal (cos signal) 120 and inputs it into the addition/subtraction function section 400-1. Output of the addition/subtraction function section 400-1 is inputted into the phase detection circuit 500-1 so that phase difference with respect to the excitation signal sin ($\omega$t) is obtained. Thus obtained value corresponds to an estimated angle output ($\phi$)-$\varepsilon(\tau)$). The reason why there are two modes is that there are two cases, that is, a case that the signal delay characteristic $\varepsilon(\tau)$ is obtained based on the resolver output signal (sin signal) 110 (mode 0s), and a case that it is obtained based on the resolver output signal (cos signal) 120 (mode 0c), as in Fig. 7.

At the timing when examination is not performed (during normal operation), the selector 607 selects the resolver output signal. While there are a resolver output signal (sin signal) 110 (b) and a resolver output signal (cos signal) 120 (c) as the resolver output signal, either of them may be selected. The signal selected by the input selector 607 is inputted into the phase detection circuit 500-2 so that phase difference with respect to the excitation signal sin($\omega$t), that is, the signal delay characteristic $\varepsilon(\tau)$ is obtained. The signal delay characteristic is used to correct estimated angle output. While the signal delay characteristic $\varepsilon(\tau)$ can be calculated using either of the sin signal 110 and the cos signal 120 of the resolver output signals, a mode can be determined such that a signal having a larger amplitude between the resolver output signals 110 and 120 is selected from the viewpoint of improving measurement accuracy by increasing a signal to noise ratio. In this way, selection of the mode 0s and the mode 0c in the input selector 607 is performed in the same way as in the example of Fig. 7. In each of the modes including the offline test, operations of the output selector 600 and the holding function section 630 are the same as in Fig. 7.

(Mode 1) As shown in Fig. 16, in the case that the normal operation function section 11 is examined for fault detection, the input selectors 603 and 604 are switched, so that a test pattern is inputted from the fault detection unit 622. Then, output of the normal operation function section 11 is inputted into the check function section 620 which then checks whether it corresponds to an expected value corresponding to the test pattern inputted from the fault detection unit or not. At that time, as shown in Fig. 16 (mode 1), the output selector 600 can select the corrected, estimated angle output $\phi$ based on the estimated angle output of the temperature characteristic identification function section 12, that is, output of the temperature characteristic correction function section 410-2. The example is the same as the example 1 in that a signal delay characteristic held in the holding function section 630 is used as the signal delay characteristic $\varepsilon(\tau)$ for correction. Thus, the normal operation function section 11 can be examined without breaking the magnetic-pole-position detection operation added with temperature characteristic correction.

(Mode 2) Similarly, in the case that the temperature characteristic identification function section 12 is examined for fault detection, the input selectors 605 and 606 are switched so that a test pattern is inputted from the fault detection unit 622. Then, output of the temperature characteristic identification function section 12 is inputted into the fault detection unit 621 which then checks whether it corresponds to an expected value corresponding to the test pattern inputted from the fault detection unit 622 (Fig. 16, mode 2).

Example 4

The above examples have been described assuming that the resolver/digital-converter is used which performs temperature characteristic correction based on output of the temperature characteristic identification function section 12 as shown in Fig. 1. In the following examples, description is made on examples where the configuration of an embodiment of the invention is used for a resolver/digital-converter that performs temperature characteristic correction according to the related art literature 3 (JP-A-9-126809) being a different system from that of Fig. 4.

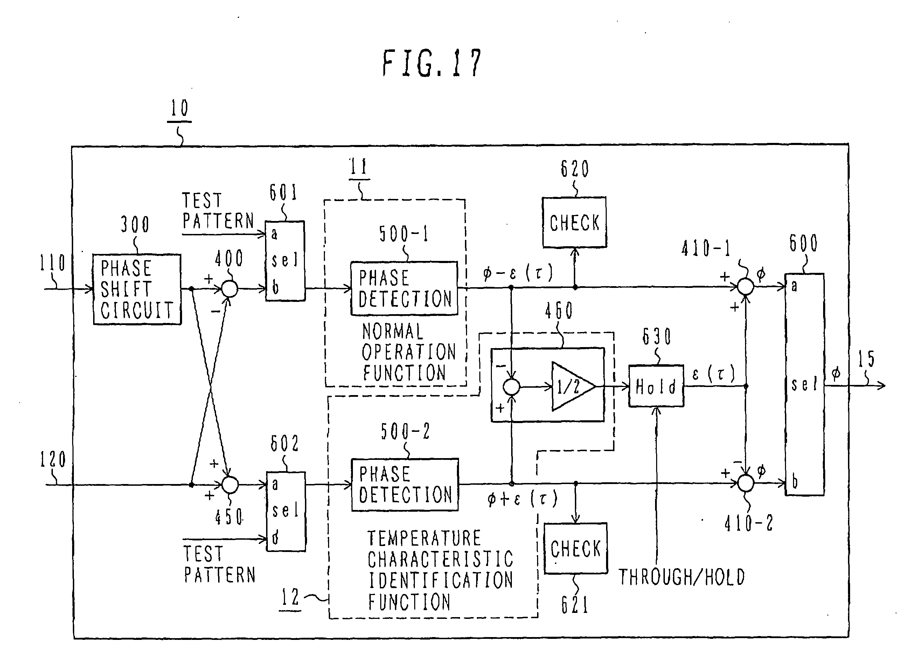

Fig. 17 shows a configuration of the example. Compared with the example 1 as shown in Fig. 4 and Fig. 7, the example is different in that it has a calculation section 460 of obtaining the signal delay characteristic $\varepsilon(\tau)$ based on both of output of the temperature characteristic identification function section 12 and output of the normal operation function section 11. Configurations and functions being not particularly described are the same as those in the example 1 as shown in Fig. 4 and Fig. 7.

Similarly to the example shown in Fig. 7, in the normal operation function section 11, the resolver output signal (sin signal) 110 is inputted, and shifted in phase by the phase shift circuit 300. The addition/subtraction function section 400 subtracts the resolver output signal (cos signal) 120 from the resolver output signal (sin signal) 110 being shifted in phase. The signal obtained by such subtraction is inputted into the phase detection circuit 500-1 via the selector 601 so that phase difference with respect to the excitation signal $\sin(\omega t)$ is obtained. Thus obtained value corresponds to an estimated angle output ($\phi-\varepsilon(\tau)$).

On the other hand, in the temperature characteristic identification function section 12, the resolver output signal (sin signal) 110 being shifted in phase by the phase shift circuit 300 and the resolver output signal (cos signal) 120 are inputted, and added in an addition/subtraction function section 450. The signal obtained by such addition is inputted into the phase detection circuit 500-2 via the selector 602 so that phase difference with respect to the excitation signal sin ($\omega t$) is obtained. Thus obtained value corresponds to an estimated angle output ($\phi+\varepsilon(\tau)$).

Furthermore, the previously obtained output of the phase detection circuit 500-1 and output of the phase detection circuit 500-2 are calculated in the calculation section 460 so that the signal delay characteristic $\varepsilon(\tau)$ is obtained. Output of the normal operation function section 11, that is, estimated angle output is corrected based on the signal delay characteristic $\varepsilon(\tau)$ in the temperature characteristic correction function section 410-1, thereby to become a corrected, estimated angle output $\phi$. Similarly, output of the temperature characteristic identification function section 12 is corrected based on the signal delay characteristic $\varepsilon(\tau)$ in the temperature characteristic correction function section 410-2, thereby to become a corrected, estimated angle output $\phi$.

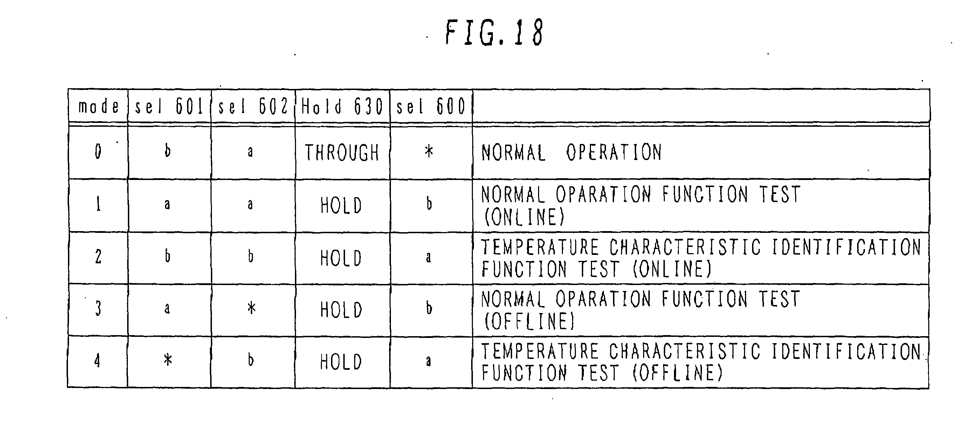

As shown in Fig. 18, operations of the input selectors 601 and 602, output selector 600, and holding function section 630 in each mode are the same as in the example 1 shown in Fig. 5. That is, operations of the input selectors 601 and 602, output selector 600, and holding function section 630 are the same as in Fig. 5 in any of the mode during normal operation without performing examination (mode 0), and mode during online test (mode 1) and mode during offline test (mode 3) of the normal operation function section 11, and mode during online test (mode 2) and mode during offline test (mode 4) of the temperature characteristic identification function section 12.

(Mode 1) In the case that the normal operation function section 11 is examined for fault detection, the input selector 601 is switched as shown in Fig. 18 so that a test pattern is inputted. Then, the check function section 620 checks whether output of the normal operation function section 11 corresponds to an expected value corresponding to the inputted test pattern or not.

(Mode 2) Similarly, in the case that the temperature characteristic identification function section 12 is examined for fault detection, the input selector 602 is switched as shown in Fig. 18 so that a test pattern is inputted. Then, the check function section 621 checks whether output of the temperature characteristic identification function section 12 corresponds to an expected value corresponding to the inputted test pattern or not.

Example 5

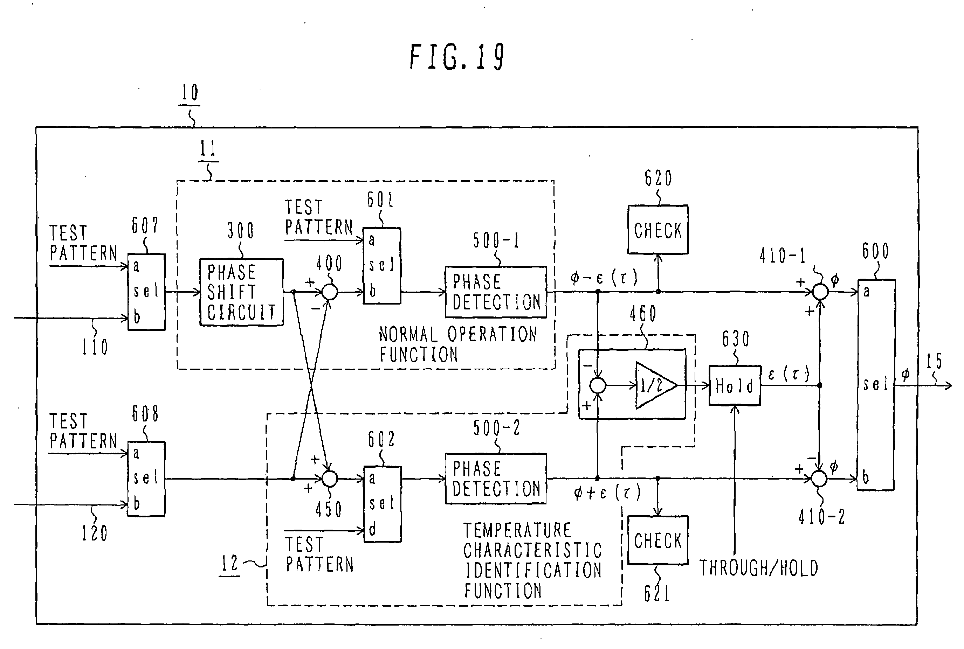

Fig. 19 shows a fifth example of an embodiment of the invention. Compared with the example 4, the example is different in that input selectors 607 and 608 for injecting a test pattern are placed in a stage previous to the phase shift circuit 300 and the addition/subtraction function section 400. Configurations being not particularly described are the same as in the example 4. The example is an example that the configuration of the example 2 (Fig. 13) is applied to the example 4 (Fig. 17).

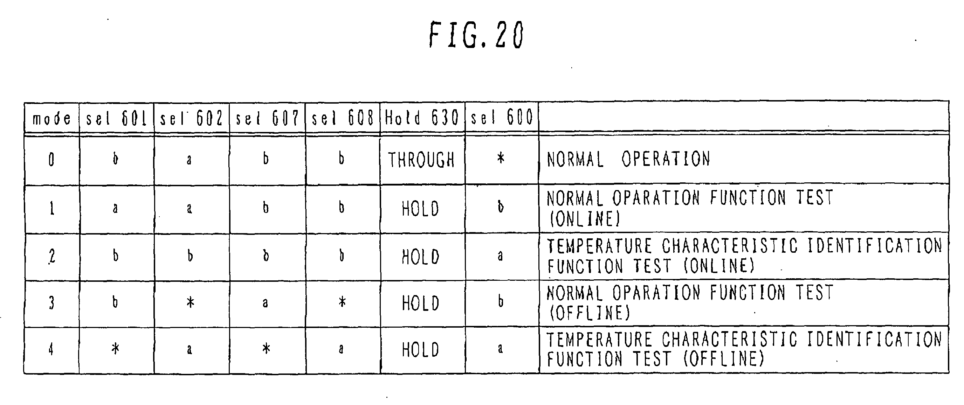

Operation of each selector in the example is shown in Fig. 20. Operations of the selectors 601 and 602 are the same as in the example 4 (Fig. 17 and Fig. 18) except for operation in modes 3 and 4 for the offline test. As shown in Fig. 20, in the modes 3 and 4, the selectors 607 and 608 select a test pattern as input, so that the offline tests of the normal mode function section 11 and the temperature characteristic identification function section 12 are performed including the phase shift circuit and the addition/subtraction function section.

Example 6

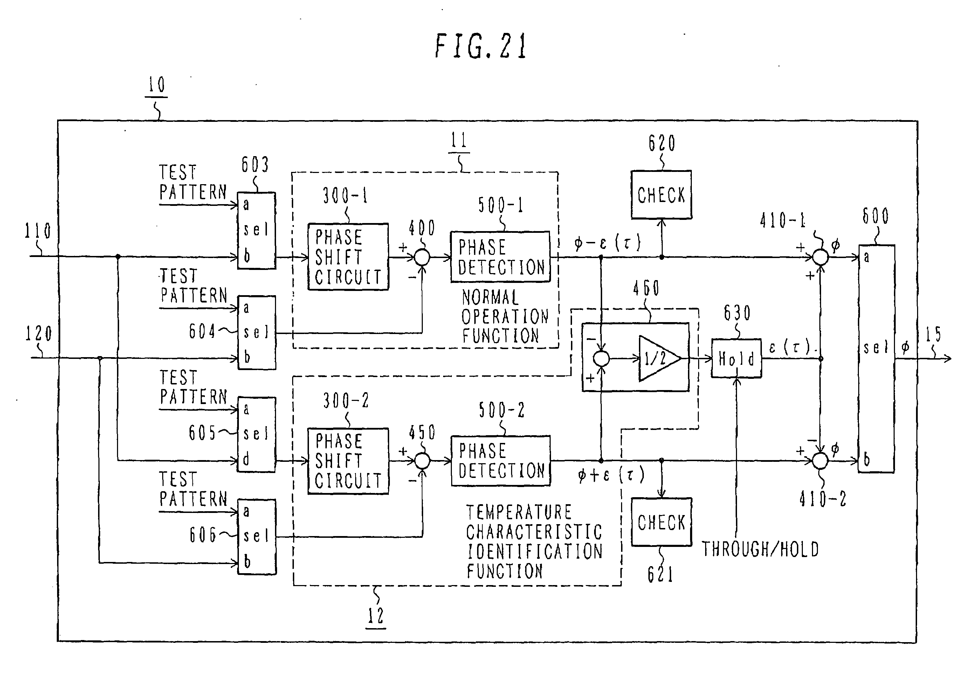

Fig. 21 shows a sixth example of an embodiment of the invention. Compared with the example 5, the example is different in that the normal mode function section 11 and the temperature characteristic identification function section 12 separately have phase shift circuits 300-1, 300-2 and addition/subtraction function sections 400-1, 400-2, and selectors 603 to 606 for injecting a test pattern are placed in a stage previous to the phase shift circuits 300-1, 300-2 and the addition/subtraction function sections 400-1, 400-2. According to the example, since the phase shift circuits and the addition/subtraction function sections can be made as objects of the online test, faults can be detected without breaking the normal magnetic-pole-position detection operation including faults in the phase shift circuits and the addition/subtraction function sections.

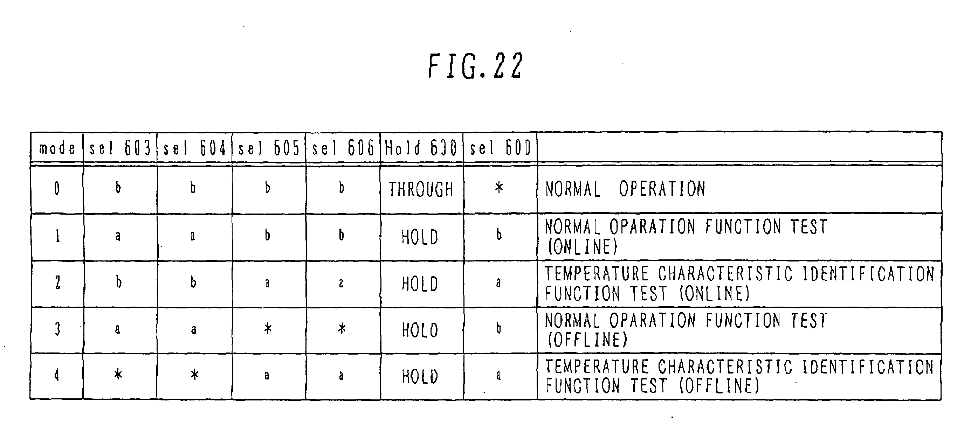

Operation of each selector in the example is shown in Fig. 22.

(Mode 0) As shown in Fig. 22, at timing when examination is not performed (during normal operation), the selectors 603 and 605 select the resolver output signal (sin signal) 110 and inputs it into the phase shift circuit 300-1. The selector 604 and 606 select the resolver output signal (cos signal) 120 and input it into the addition/subtraction function sections 400 and 450. In the addition/subtraction function sections 400 and 450, the resolver output signal (cos signal) 120 is subtracted from the resolver output signal (sin signal) 110 being shifted in phase. The signal obtained by such subtraction is inputted into the phase detection circuit 500-1 so that phase difference with respect to the excitation signal $\sin(\omega t)$ is obtained. Thus obtained value corresponds to the estimated angle output ($\phi - \varepsilon(\tau)$). Operation of the selector 600 and the holding function section 630 is the same as in Fig. 7 in each mode including the offline test.

(Mode 1) As shown in Fig. 22, in the case that the normal operation function section 11 is examined for fault detection, the input selectors 603 and 604 are switched, so that a test pattern is inputted from the fault detection unit 622. Then, output of the normal operation function section 11 is inputted into the check function section 620 which then checks whether it corresponds to an expected value corresponding to the test pattern inputted from the fault detection unit or not. At that time, as shown in Fig. 22 (mode 1), the output selector 600 can select the corrected, estimated angle output $\phi$ based on estimated angle output of the temperature characteristic identification function section 12, that is, output of the temperature characteristic correction function section 410-2.

The example is the same as the example 1 in that a signal delay characteristic held in the holding function section 630 is used as the signal delay characteristic $\varepsilon(\tau)$ for correction. Thus, the normal operation function section 11 can be examined without breaking the magnetic-pole-position detection operation added with temperature characteristic correction.

(Mode 2) Similarly, in the case that the temperature characteristic identification function section 12 is examined for fault detection, the input selectors 605 and 606 are switched so that a test pattern is inputted from the fault detection unit 622. Then, output of the temperature characteristic identification function section 12 is inputted into the check function section 621 which then checks whether it corresponds to an expected value corresponding to the test pattern inputted from the fault detection unit 622 (Fig. 22, mode 2). In this case, the output selector 600 can select the corrected, estimated angle output $\phi$ based on the estimated angle output of the normal operation function section 11, that is, output of the temperature characteristic correction function section 410-1. Again in this case, a signal delay characteristic held in the holding function section 630 is used as the signal delay characteristic $\varepsilon(\tau)$ for correction.

Example 7

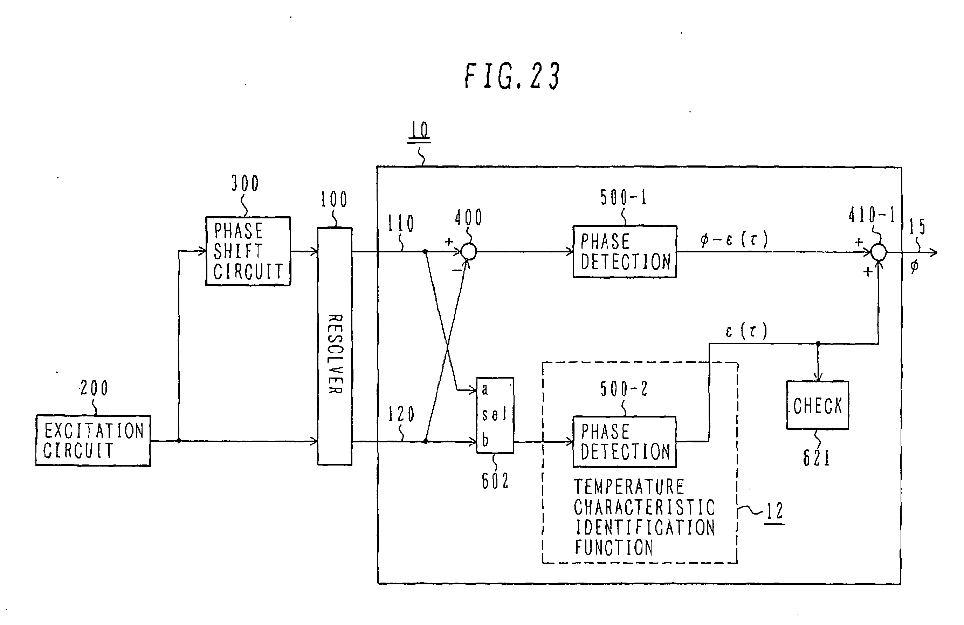

Fig. 23 shows an example for detecting a phase short fault. The phase short fault is a fault mode of short between a winding of the resolver output signal (sin signal) 110 of the resolver 100 and a winding of the resolver output signal (cos signal) 120. In this example, excitation output from the excitation circuit 200 is shifted in phase in the phase shift circuit 300 and then inputted into an input terminal corresponding to one of the output signals (for example, the resolver output signal (sin signal) 110 in the example). In the relevant configuration, the phase shift circuit provided in the resolver/digital-converter 10 in other examples is unnecessary. That is, the example is in such a configuration that the phase shift circuit 300 in the resolver/digital-converter 10 is moved into a stage previous to the resolver from a stage in the example of Fig. 1. Furthermore, in the example, the selector 602 selects one of the resolver output signal (sin signal) 110 and the resolver output signal (cos signal) 120, and inputs it into the phase detection circuit 500-2 whose output is checked by the check function section 621.

In the examples as shown in Figs. 1, 4, 7, 13, 15 and 17, as shown in the expressions (2) and (3) or the expressions (4) and (5), signals, in which common-mode carrier waves are modulated to have amplitude in proportion to sine or cosine of a rotation angle $\theta$ of the resolver, are obtained as the resolver output signals 110 and 120.

On the contrary, in the example as shown in Fig. 23, the resolver output signals 110 and 120 are signals expressed as follows respectively:

$$A(\tau) \bullet \sin(\omega t + \varepsilon(\tau) + \alpha) \bullet \sin\theta, \qquad (6)$$

$$A(\tau) \bullet \sin(\omega t + \varepsilon(\tau)) \bullet \cos\theta, \qquad (7)$$

in which carrier waves being different in phase by $\alpha$ due to a shift by the phase shift circuit 300 are modulated to have amplitude in proportion to sine or cosine of a rotation angle $\theta$ of the resolver.

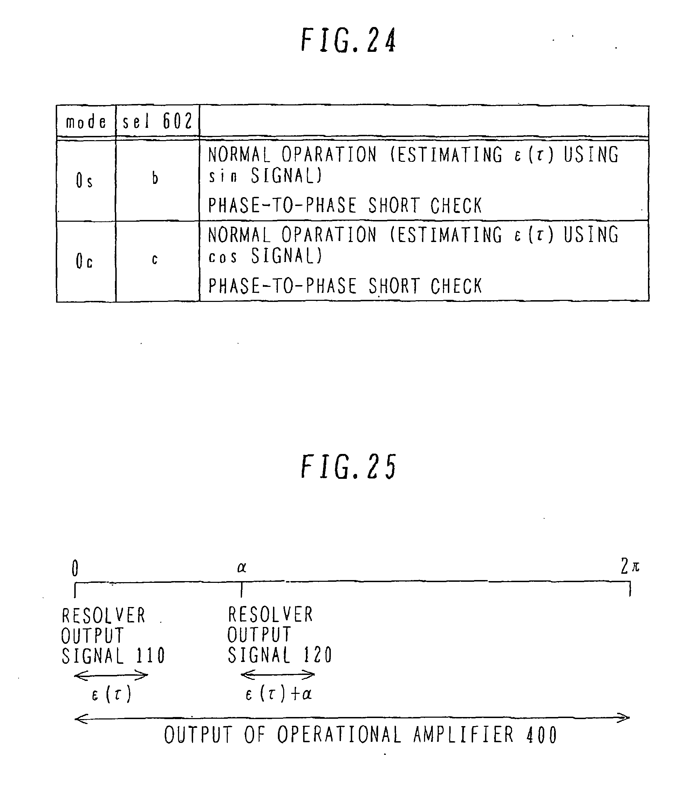

Therefore, the resolver output signals 110 and 120 can be distinguished by phases of carrier waves as shown in Fig. 25, and when the phase short fault occurs, phase shift is induced since a carrier wave signal having a different phase is added to each signal. Thus, by checking the output of the phase detection circuit 500-2 by the check function section 621, the phase short fault can be detected.

As shown in Fig. 24 (mode 0s), when the selector 602 selects the resolver output signal (sin signal) 110, the signal delay characteristic $\varepsilon(\tau)$ can be estimated based on the signal. On the other hand, as shown in Fig. 24 (mode 0c), when the selector 602 selects the resolver output signal (cos signal) 120, the signal delay characteristic $\varepsilon(\tau)$ can be estimated based on the signal. Furthermore, by monitoring the phases of the carrier waves of the resolver output signal (sin signal) 110 and the resolver output signal (cos signal) 120, occurrence of the phase short fault can be detected. As described hereinbefore, according to the example, the temperature characteristic can be corrected, in addition, and the phase short fault can be detected.

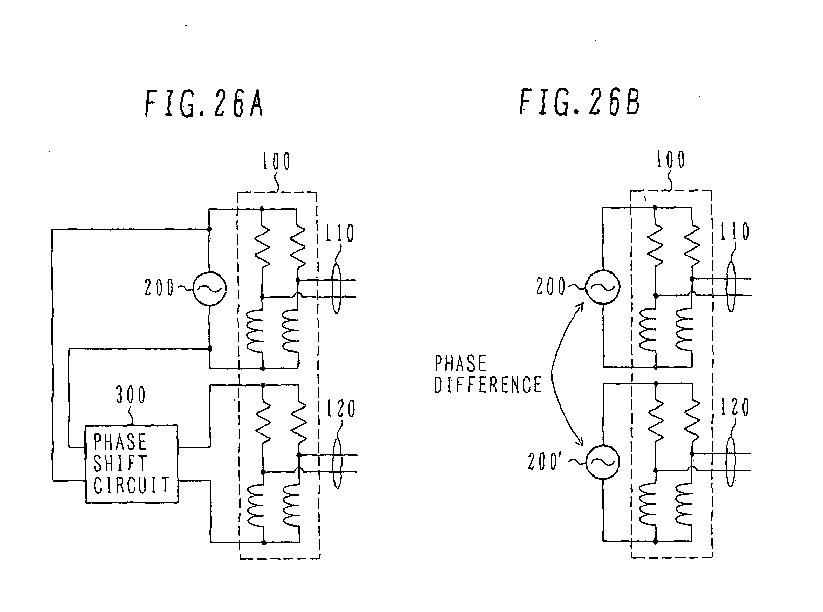

Figs. 26A and 26B show a resolver 100 for Fig. 23 and a method of driving the resolver. The resolver used in the example of Fig. 23 is in a type that a common winding is provided for the excitation signal and the resolver output signals 110, 120 as shown in Fig. 3B. As shown in Figs. 26A and 26B, an excitation signal is applied from the excitation circuit in a different phase to a winding for each of the resolver output signal (sin signal) 110 and the resolver output signal (cos signal) 120. Fig. 26A shows an example where the excitation circuit 200 applies its output to the winding for the resolver output signal (sin signal) 110, and applies an excitation signal having a different phase to the winding for the resolver output signal (cos signal) 120 via the phase shift circuit 300. Fig. 26B shows an example where the windings for the resolver output signal (sin signal) 110 and the resolver output signal (cos signal) 120 are applied with excitation signals having different phases from separate excitation circuits 200 and 200'.

The above configuration can be used in combination with each of the circuits of the examples 1 to 7, and each resolver/digital-converter can be allowed to have a function of detecting the phase short fault of the resolver.

Example 8

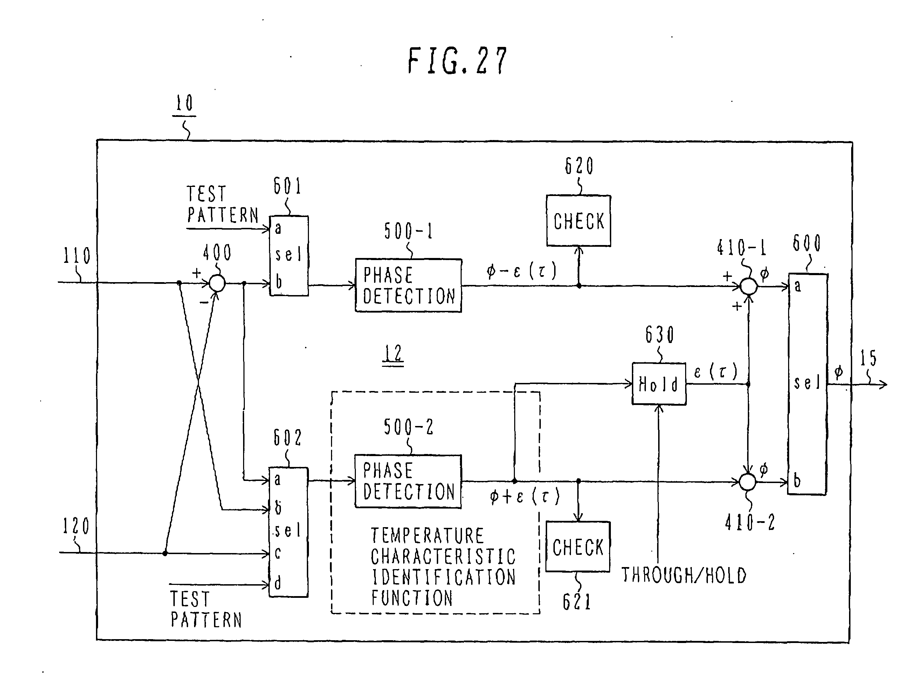

Fig. 27 shows an eighth example of an embodiment of the invention. This is an example where the example 1 (Fig. 7) is added with the phase short detection function as described in the example 7. The example has a configuration that the phase shift circuit 300 in the resolver/digital-converter 10 in the example in Fig. 7 is moved into a stage previous to the resolver 100 (Fig. 7 does not show the resolver 100).

In the normal operation function section 11, an inputted resolver output signal (cos signal) 120 is subtracted from an inputted resolver output signal (sin signal) 110 with in the addition/subtraction function section 400. The signal after the subtraction is inputted into the phase detection circuit 500-1 via the selector 601 so that phase difference with respect to the excitation signal $\sin(\omega t)$ is obtained. Thus obtained value corresponds to an estimated angle output $(\phi)-\varepsilon(\tau)$.

In the temperature characteristic identification function section 12, the selector 602 selects one of the resolver output signals 110 and 120. The selected signal is inputted into the phase detection circuit 500-2 so that phase difference with respect to the excitation signal $\sin(\omega t)$, that is, the signal delay characteristic $\varepsilon(\tau)$ is obtained. The signal delay characteristic $\varepsilon(\tau)$ is outputted to the holding circuit 603.

Output of the normal operation function section 11, that is, estimated angle output is corrected based on the signal delay characteristic $\varepsilon(\tau)$ in the temperature characteristic correction function section 410-1, thereby to become a corrected, estimated angle output $\phi$. Similarly, the estimated angle output outputted by the temperature characteristic identification function section 12 is corrected based on the signal delay characteristic $\varepsilon(\tau)$ in the temperature characteristic correction function section 410-2, thereby to become a corrected, estimated angle output $\phi$.

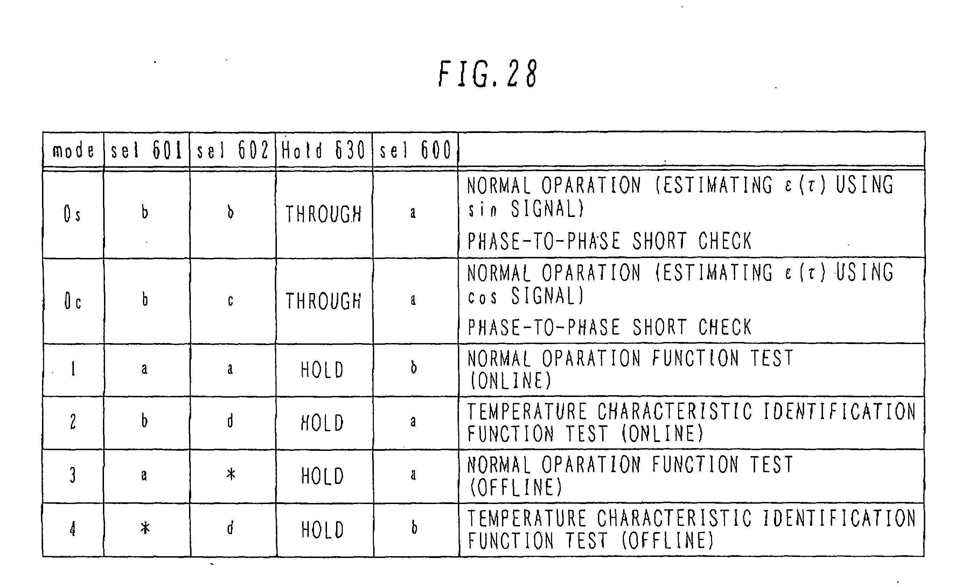

(Mode 0s, 0c) As shown in Fig. 28, at timing when examination is not performed (during normal operation), the input selector 601 selects output of the addition/subtraction function section 400, in which the inputted resolver output signal (cos signal) 120 is subtracted from the resolver output signal (sin signal) 110 being shifted in phase by the phase shift circuit 300. The signal selected by the selector 601 is inputted into the phase detection circuit 500-1 so that phase difference with respect to the excitation signal $\sin(\omega t)$ is obtained. Thus obtained value corresponds to the estimated angle output $(\phi)-\varepsilon(\tau)$.

At the timing when examination is not performed (during normal operation), the selector 602 selects a resolver output signal. While there are the resolver output signal (sin signal) 110 (b) and the resolver output signal (cos signal) 120 (c) as the resolver output signal, either of them may be selected. The signal selected by the input selector 602 is inputted into the phase detection circuit 500-2 so that phase difference with respect to the excitation signal $\sin(\omega t)$, that is, the signal delay characteristic $\varepsilon(\tau)$ is obtained. The signal delay characteristic is used to correct estimated angle output.

While the signal delay characteristic $\varepsilon(\tau)$ can be calculated using either of the sin signal 110 and the cos signal 120 of resolver output signals, a mode can be determined such that a signal having a larger amplitude is selected between the resolver output signals 110 and 120 from the viewpoint of improving measurement accuracy by increasing a signal to noise ratio. At that time, phases of carrier waves of the resolver output signals 110 and 120 are checked according to the principle as described before so that occurrence of the phase short fault can be detected. Operations in other modes are the same as in the example of Fig. 7.

Example 9

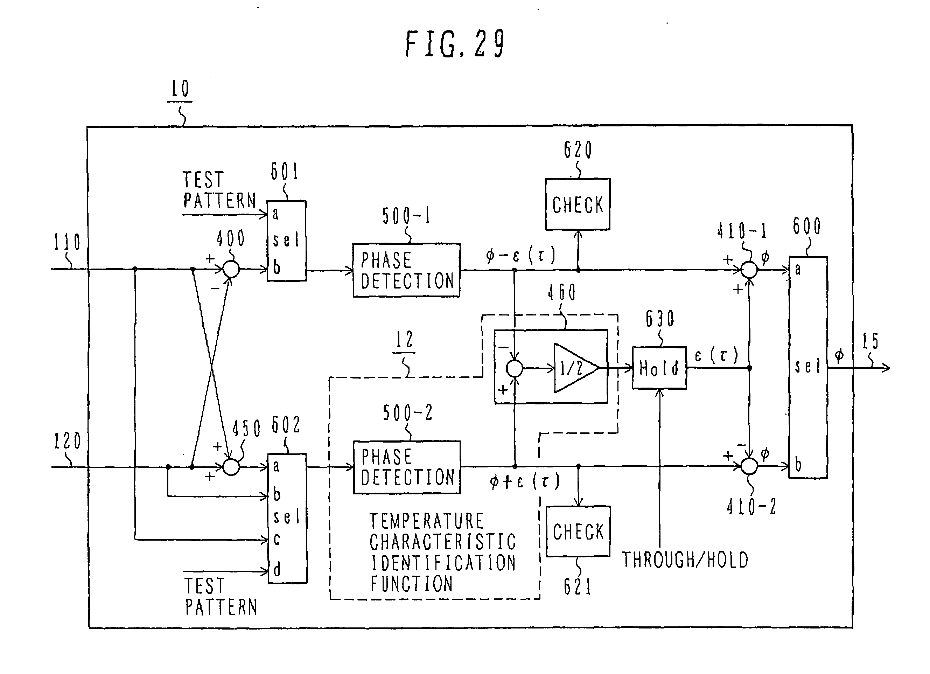

Fig. 29 shows a ninth example of an embodiment of the invention. The example is an example where the example 5 (Fig. 19) is added with the phase short detection function as described in the example 7. Configurations and functions being particularly not described are the same as in the example 5. As shown in Fig. 26A, the example has a configuration that the phase shift circuit is provided in a stage previous to the resolver 100, and the resolver output signals 110 and 120 are directly inputted into the input selector 602 to detect the phase difference between them.

First, operation of the normal operation function section 11 is the same as in the example 6.

Next, in the temperature characteristic identification function section 12, the resolver output signal (sin signal) 110 is added with the inputted resolver output signal (cos signal) 120 in the addition/subtraction function section 450. The signal after the addition is inputted into the phase detection circuit 500-2 via the selector 602 so that phase difference with respect to the excitation signal $\sin(\omega t)$ is obtained. Thus obtained value corresponds to an estimated angle output $(\phi)+\epsilon(\tau)$. Furthermore, previously obtained output of the phase detection circuit 500-1 and output of the phase detection circuit 500-2 are calculated in the calculation section 460 so that the signal delay characteristic $\epsilon(\tau)$ is obtained. Output of the normal operation function section 11, that is, estimated angle output is corrected based on the signal delay characteristic $\epsilon(\tau)$ in the temperature characteristic correction function section 410-1, thereby to become a corrected, estimated angle output $\phi$. Similarly, estimated angle output outputted by the temperature characteristic identification function section 12 is corrected based on the signal delay characteristic $\epsilon(\tau)$ in the temperature characteristic correction function section 410-2, thereby to become a corrected, estimated angle output $\phi$.

Operation at the timing when examination is not performed (during normal operation) is the same as in the example 6 (Fig. 20) . Operations in the modes 1 to 4 are the same as in the example 6 (Fig. 20).

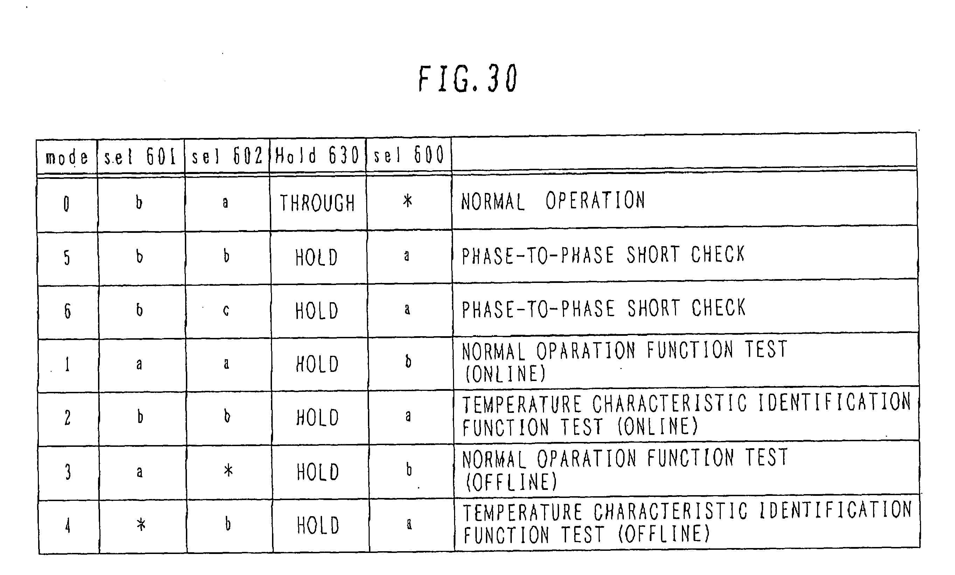

(Mode 5, 6) These modes are for detecting the phase short fault. As shown in Fig. 30 (mode 5), the selector 602 selects the resolver output signal (cos signal) 120 (c), and the phase detection circuit 500-2 detects and checks the phase of a carrier wave of the signal. In addition to such operation, as shown in Fig. 30 (mode 6), the input selector 602 selects the resolver output signal (sin signal) 110 (b), and the phase detection circuit 500-2 detects and checks the phase of a carrier wave of the signal. Thus, the phase short fault in the resolver can be detected.

At that time, since the temperature characteristic identification function section 12 is used for detecting the phase short fault, the signal delay characteristic $\epsilon(\tau)$ is not obtained. Thus, a temperature characteristic is compensated using a value of a signal delay characteristic held in the holding function section 630 immediately before such detection.

While not shown, in addition to the examples of Figs 27 and 29, as shown in Figs. 13 and 19, selectors for injecting a test pattern are placed in a stage previous to the addition/subtraction function sections 400 and 450, so that the addition/subtraction function sections 400 and 450 can be made objects of the offline test, consequently faults in the phase shift circuit and the addition/subtraction function sections can be detected.

While not shown, in addition to the examples of Figs 27 and 29, as shown in Figs. 15 and 21, the normal mode function section 11 and the temperature characteristic identification function section 12 separately have the addition/ subtraction function sections 400 and 450, and selectors for injecting a test pattern are placed in stages previous to the separately provided, addition/subtraction function sections 400 and 450, so that the addition/subtraction function sections 400 and 450 can be made objects of the offline test, and consequently faults in the phase shift circuit and the addition/ subtraction function sections can be detected.

Example 10

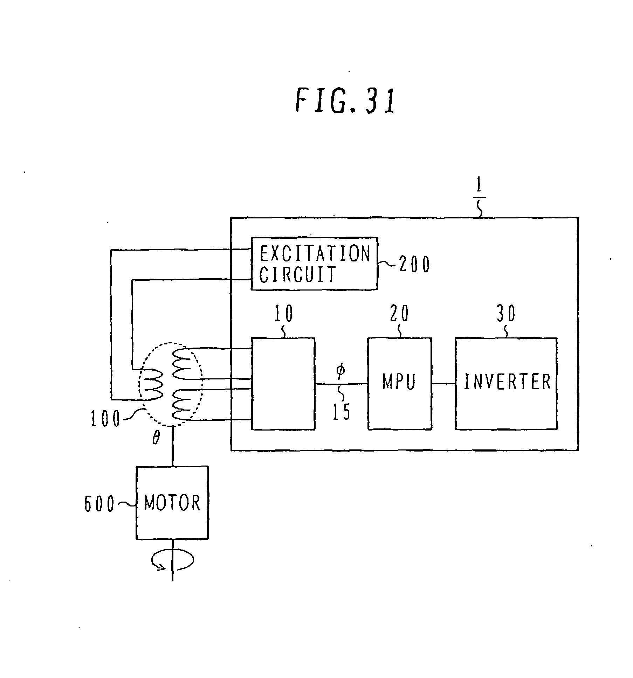

Fig. 31 shows an example that the resolver/digital-converter 10 provided by an embodiment of the invention is applied to a motor controller 1 and a motor control system. An excitation signal 230 outputted from the excitation circuit 200 is inputted into the resolver 100. A rotation shaft of the resolver 100 is rotated in one with a rotation shaft of the motor 600, so that a signal depending on a rotation angle $\theta$ of the motor is outputted to be inputted into the resolver/ digital-converter 10. The resolver/digital-converter 10 estimates the rotation angle $\theta$ based on the inputted signal, and outputs the estimated value $\phi$. A microprocessing unit (MPU) 20 sends an instruction to an inverter 30 for generating a three-phase alternating current having an appropriate phase based on the estimated value $\phi$, and the inverter 30 outputs the three-phase alternating current according to the instruction from the MPU 20 to drive the motor 600. The MPU 20 preferably performs vector control to achieve smooth and accurate torque control, and a PWM (pulse width modulation) wave indicating duty of output of each phase is preferably used for the switching instruction inputted from the MPU 20 into the inverter to generate the three-phase alternating current in the motor.

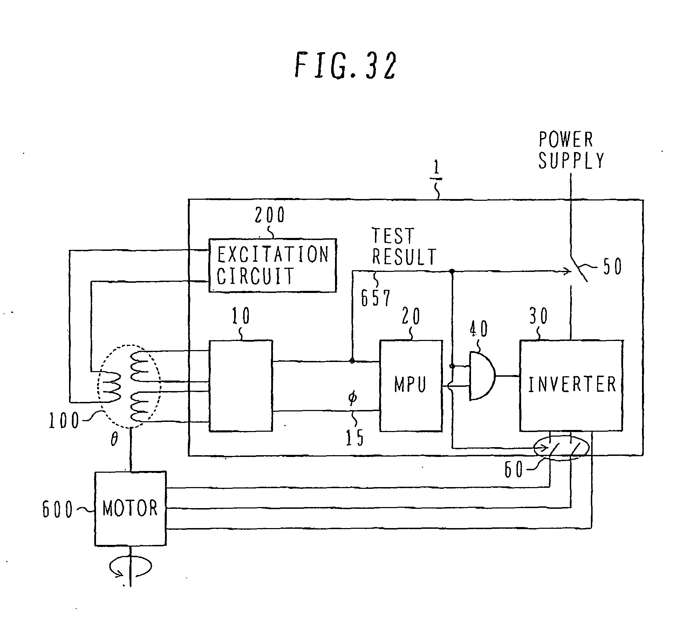

Furthermore, Fig. 32 shows an example for achieving fail safe operation using a fault detection result (test result) 657 from the resolver/digital-converter 10 provided by an embodiment of the invention. The test result 657 is inputted into the MPU 20 so that a drive signal to the inverter 30 is stopped when an abnormal condition occurs. Furthermore, a configuration that the test result 657 is inputted into a logic circuit 40 may be used, so that a drive signal to the inverter 30 is stopped when an abnormal condition occurs.

Moreover, a switch or relay 50 inserted into a power line to the inverter 30 can be controlled so that the switch or relay 50 is turned off when an abnormal condition occurs, in order to stop power supply to the inverter 30. Furthermore, a switch or relay 60 inserted into a drive output line of the inverter 30 can be controlled so that the switch or relay 60 is turned off when an abnormal condition occurs, in order to stop drive output to the motor 600. By combining at least one, or at least two of the above configurations, when an abnormal condition occurs in the resolver 100 or the resolver/digital-converter 10, operation of the motor 600, that is, torque generation by the motor 600 is stopped. When torque generation by the motor 600 is stopped, assist power for an electric power steering is lost, however, since torque of preventing steering operation of a driver is not induced by a fault, a control object can be made in a fail safe condition.

While not shown, a plurality of resolver/digital-converters 10 are redundantly provided, and thereby a fault in the resolver/digital-converter 10 itself can be detected. Furthermore, when redundantly provided, resolver/digital-converters 10 in a different type are combined, a weak point in the type can be compensated due to design diversity, and consequently more secure control system can be achieved.

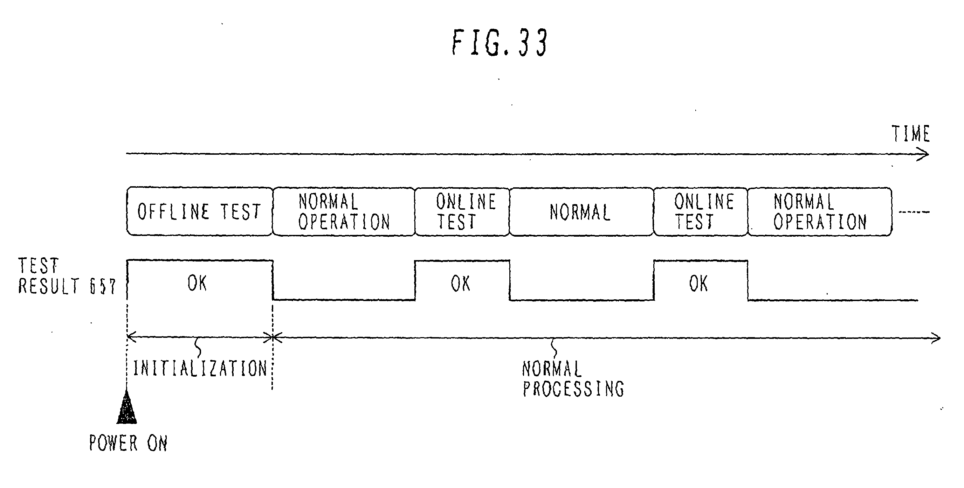

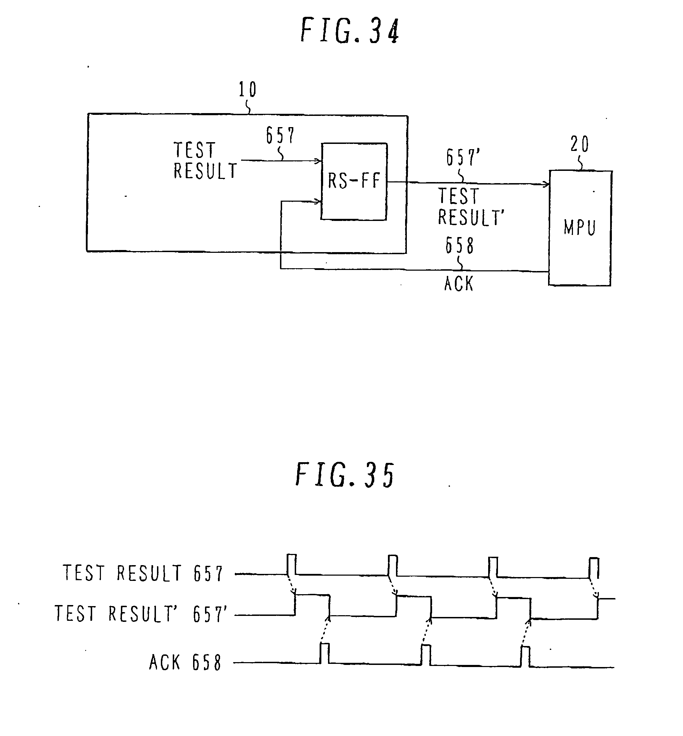

To avoid influence of a fault of signal fixation, it is desirable that the test result 657 is not a signal having a fixed value such as H (high level) or L (low level), but a signal being alternately changed in a manner of H, L ••• in a normal condition. For example, there is a method that a test result 657 showing OK is outputted only when a test is carried out as shown in Fig. 33, or a method that a test result 657 is temporarily received by RS-FF (reset/set flip-flop) as shown in Fig. 34, then a test result 657' is cleared using an acknowledgement signal (ACK) 658 from the microprocessing unit 20.

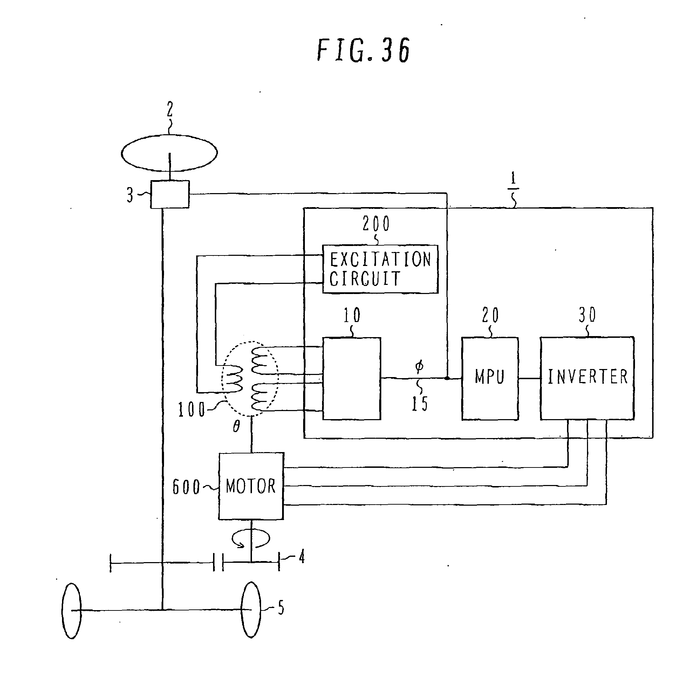

Fig. 36 shows an example that the resolver/digital-converter 10 provided by an embodiment of the invention is applied to an electric power steering. In addition to the motor controller 1 and the motor control system of Fig. 26, an output shaft of the motor 600 is mechanically coupled with a steering wheel 2, torque sensor 3, and steering mechanism 5 via a deceleration mechanism 4. Operating force of a driver is detected by the torque sensor 3, and the motor controller 1 controls the motor 600 so as to output assist torque depending on the operating force.

While the example of the electric power steering was shown hereinbefore, when a mechanism of actuating a brake via the deceleration mechanism 4 is coupled with the output shaft of the motor 600 instead of the steering mechanism 5, an electric brake can be achieved.

Example 11

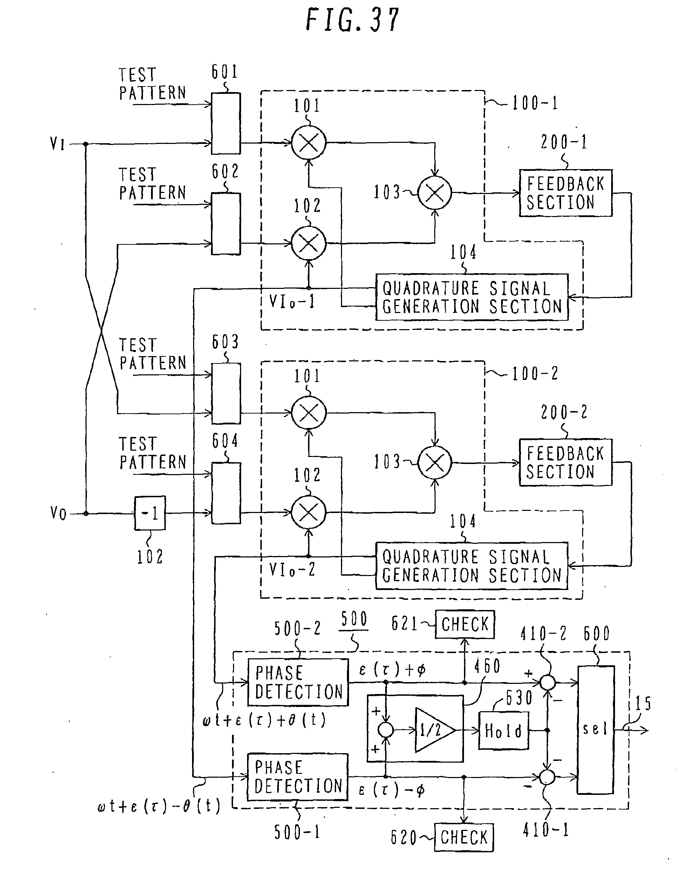

Fig. 37 shows an example where the invention is applied to a "phase difference measurement section 500" of a resolver/digital-converter disclosed in Fig. 21 of the related art literature 2 (JP-A-2005-34208). Terms and reference numerals according to the literature are shown in italic in the figure and with a mark " " in this specification.

In consideration of a signal delay characteristic of a resolver, inputs "VIo-1" and "VIo-2" into the "phase difference measurement section 500" are expressed by the following equations respectively:

$$\text{VIo-1}=\cos(\omega t+\varepsilon(\tau)+\theta(t)),$$

$$\text{VIo-2}=\cos(\omega t+\varepsilon(\tau)-\theta(t)).$$

In a method according to the literature 3, since $\varepsilon(\tau)$ can be canceled by obtaining phase difference thereof, machine difference (variation between individuals) in temperature characteristic or resolver can be canceled.

Here, according to an embodiment of the invention, when phase differences with respect to $\cos(\omega t)$ are obtained in the phase detection circuits 500-1 and 500-2, outputs $\varepsilon(\tau)+\phi$ and $\varepsilon(\tau)-\phi$ are obtained respectively. However, $\phi$ is an estimated value of $\theta$. Furthermore, output of the detection circuit 500-1 and output of the phase detection circuit 500-2 are calculated in the calculation section 460 so that the signal delay characteristic $\varepsilon(\tau)$ is obtained, which is held by the holding function section 630 as necessary. Output of the phase detection circuit 500-1, that is, estimated angle output is corrected based on the signal delay characteristic $\varepsilon(\tau)$ in the temperature characteristic correction function section 410-1, thereby to become a corrected, estimated angle output $\phi$. Similarly, output of the phase detection circuit 500-2, that is, estimated angle output is corrected based on the signal delay characteristic $\varepsilon(\tau)$ in the temperature characteristic correction function section 410-2, thereby to become a corrected, estimated angle output $\phi$. Furthermore, the selector 600 selects output of one of the temperature characteristic correction function sections 410-1 and 410-2 as final output 15.

According to the above configuration, although both "complex signal processing sections 100-1 and 100-2" need to operate based on a signal from the resolver in order to obtain the signal delay characteristic $\varepsilon(\tau)$ as in other examples, once the signal delay characteristic $\varepsilon(\tau)$ is obtained, only one of the "complex signal processing sections 100-1 and 100-2" is operated, and the estimated angle output $\phi$ is obtained by correcting output of one of the phase detection circuits 500-1 and 500-2 based on the signal delay characteristic $\varepsilon(\tau)$ held in the holding function section 630. Therefore, a test pattern is inputted into one of the "complex signal processing sections 100-1 and 100-2" through selectors 601 to 604, so that output of one of the phase detection circuits is checked by the check function section 620 or 621, and thereby the output can be checked online.

While the example where an embodiment of the invention is applied to Fig. 21 of the related art literature 2 has been described hereinbefore, it can be also applied to a configuration disclosed in Fig. 30 of that literature.

Example 12

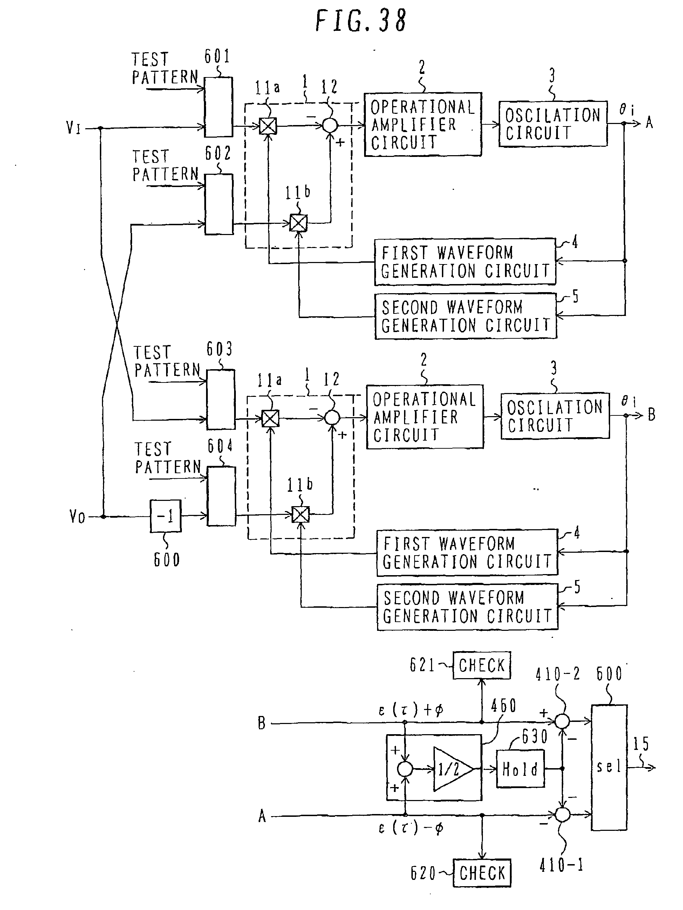

Furthermore, it will be appreciated that in the case that a phase is detected by a circuit according to the related art literature 4 (JP-A-7-131972), related art literature 5 (JP-A-9-133718), and related art literature 5 (JP-A-2005-3530) having a phase detection circuit based on essentially the same principle as that of the related art literature 2, an embodiment of the invention can be similarly applied. In particular, when a method where an "oscillation circuit 3" outputs an "estimated phase $\theta$i" as shown in the related art literature 6 is applied to a configuration of the related art literature 2, an embodiment of the invention can be applied without needing the phase detection circuits 500-1 and 500-2 by directly inputting the "estimated phase $\theta$i" as shown in Fig. 38.

Example 13

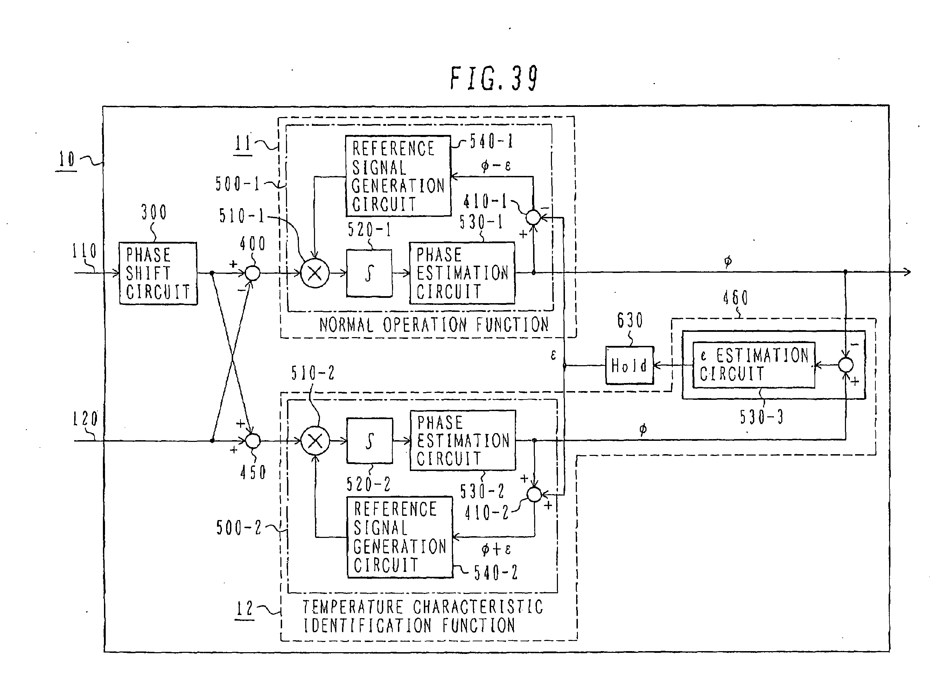

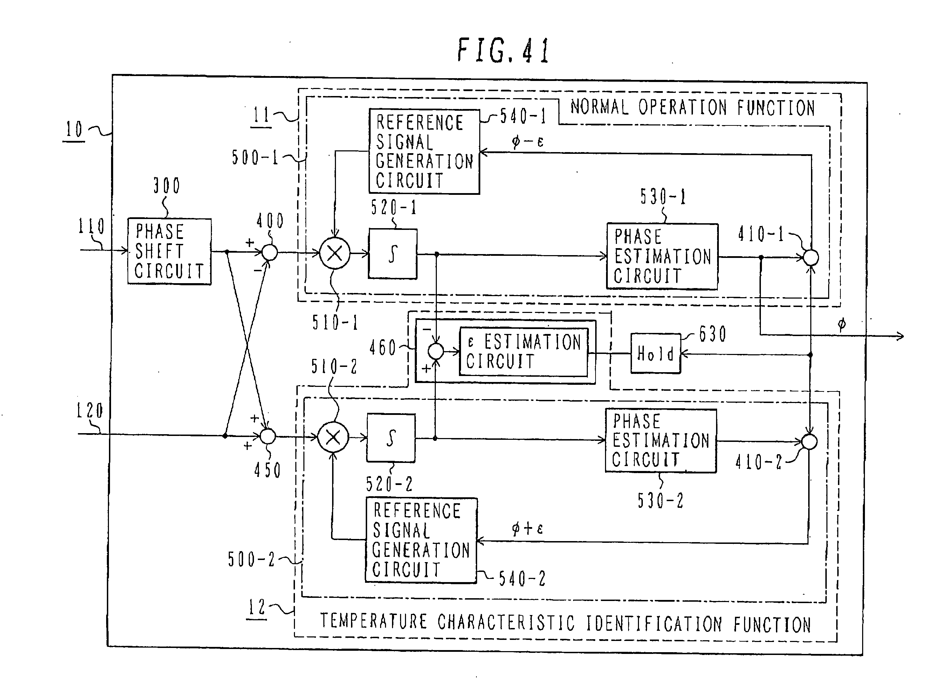

For the temperature characteristic correction function of the resolver, methods as shown in Figs. 39 and 41 are considered in addition to the methods of Fig. 1 and the related art literature 3.

Fig. 39 shows an example where a method is used in which a phase of a reference signal is allowed to follow an input signal based on a correlation function value between the input signal and the reference signal, the method being shown in JP-A-2005-207960 previously filed by the inventors as phase detection circuits 500-1 and 500-2, thereby correction of the signal delay characteristic $\varepsilon(\tau)$ obtained by the calculation section 460 is added into a loop that the phase of the reference signal is allowed to follow the input signal, and thereby a temperature characteristic of the resolver is corrected.

In each of the phase detection circuits 500-1 and 500-2, a multiplier 510-1 or 510-2 multiplies output of a reference generation circuit 540-1 or 540-2 by an input signal, then the product is inputted into an integrating circuit 530-1 or 530-2, and then inputted into a phase estimation circuit 520-1 or 520-2. Phase difference $\phi$ estimated by the phase estimation circuit 530-1 or 530-2 is outputted as an estimated value of $\theta$, and inputted into the reference generation circuit 540-1 or 540-2 while being offset by the signal delay characteristic $\varepsilon(\tau)$ obtained by the calculation section 460 in a temperature characteristic correction function section 410-1 or 410-2, and consequently the reference generation circuit 540-1 or 540-2 outputs a reference signal shifted in phase by $(\phi\pm\varepsilon)$ with respect to an excitation signal as shown in Fig. 3 of JP-A-2005-207960.

The calculation section 460 gives feedback to the phase detection circuits 500-1 and 500-2 configuring the normal operation function section 11 and the temperature characteristic identification function section 12 such that both of output of the temperature characteristic identification function section 12 and output of the normal operation function section 11 correspond to each other.

When the reference signal generated by the reference signal generation circuit 540 is previously allowed to have phase-offset of 90 degrees as shown in Fig. 16 of JP-A-2005-207960, a relationship between the phase difference between a reference signal 546 and an input signal in, and a correlation function value is as shown in Fig. 17 of JP-A-2005-207960. When the phase difference between the reference signal 546 and the input signal in is 0, the correlation function value is 0, and the phase difference $(\theta-\phi)$ is positive, the correlation function value is positive; and when the phase difference $(\theta-\phi)$ is negative, the correlation function value is negative. That is, it is known that whether a value of $\phi$ is to be increased or to be decreased when the phase difference is not 0 can be determined by positive or negative of the correlation function value, and $\phi$ is increased when the correlation function value is positive, and $\phi$ is decreased when the correlation function value is negative, and thereby the phase difference can be allowed to approach 0. Therefore, when operation that the value of $\phi$ is increased or decreased in the phase estimation circuit 530 depending on polarity of the correlation function value is repeated, convergent operation is continued until phase difference is eliminated.

In this case, an $\varepsilon$ estimation circuit 530-3 configuring the calculation section 460 operates to increase or decrease an output value depending on a sign of an input value, and thus converge the input value until it becomes zero as the phase estimation circuits 530-1 and 530-2. Typically, a PI control system is often used for such application. Since change in $\varepsilon(\tau)$ is gradual compared with $\theta$, when cutoff frequency of the $\varepsilon$ estimation circuit 530-3 is set low compared with cutoff frequency of the phase estimation circuits 530-1 and 530-2, convergence is excellent.

Accordingly, the phase detection circuits 500-1 and 500-2 generally perform convergent operation such that output of reference signal generation circuits 540-1 and 540-2 having phases $\phi+\varepsilon$ and $\phi-\varepsilon$ respectively correspond in phase to input signals having phases $\theta+\varepsilon$ and $\theta-\varepsilon$ respectively. Therefore, outputs $\phi$ of the phase estimation circuits 530-1 and 530-2 converge to $\theta$, that is, the phase detection circuits operate to detect phases of input signals after the signal delay characteristic $\varepsilon(\tau)$ has been corrected.

In a method where a method of JP-A-2005-207960 previously filed by the inventors is simply applied to a phase detection circuit of the related art literature 3, variation of several LSB in width known as hunting or limit cycle is found in output of the phase detection circuit as a phenomenon particular to a method where feedback operation by a digital circuit is performed. On the contrary, according to the example as shown in Fig. 39, the hunting or limit cycle in output of an estimation result of the signal delay characteristic $\varepsilon(\tau)$ by the $\varepsilon$ estimation circuit 530-3 having a lower cutoff frequency is increased, and the hunting or limit cycle in output of the phase detection circuits 500-1 and 500-2 having a higher cutoff frequency is decreased. Furthermore, the example has an advantage in that hunting or limit cycle in an estimated value of the signal delay characteristic $\varepsilon(\tau)$ serves as a dither having an effect of substantially improving resolution of the digital circuit to prevent the hunting or limit cycle in output of the phase detection circuits 500-1 and 500-2.

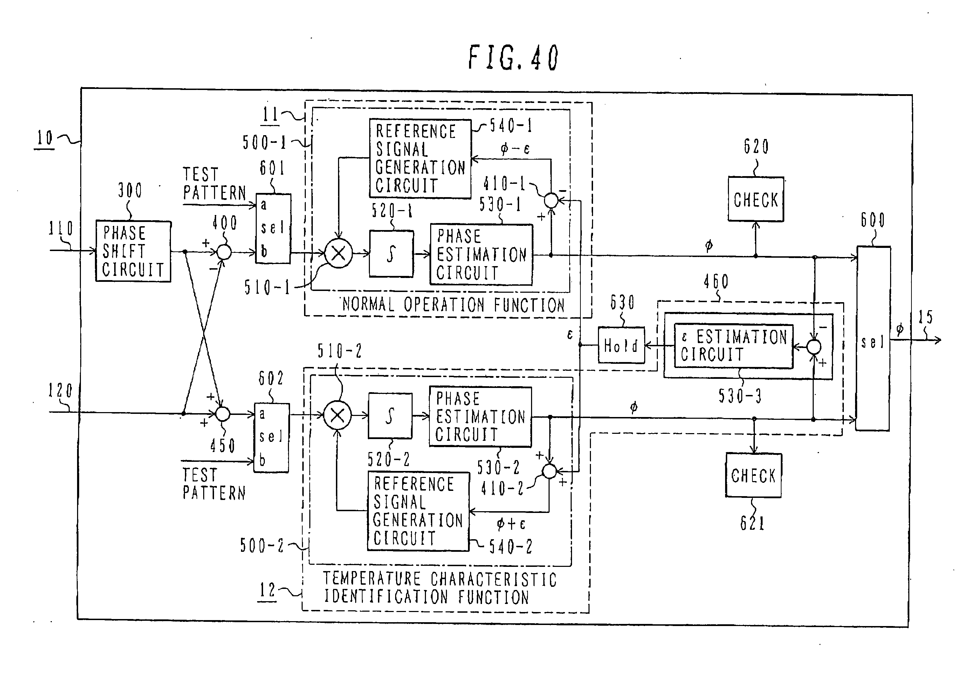

Fig. 40 shows an example where a configuration of an embodiment of the invention is applied to the example of Fig. 39. Compared with the example of Fig. 17, the example is different only in the configurations of the temperature characteristic identification function section 12 and the normal operation function section 11 as previously described in Fig. 39, and other configurations and operation are the same as in Fig. 17. Therefore, operation of the selectors in each mode is also as shown in Fig. 18.

Example 14

Fig. 41 shows an example where the temperature characteristic of the resolver is corrected using the method as shown in JP-A-2005-207960 previously filed by the inventors as the phase detection circuits 500-1 and 500-2, similarly to Fig. 39.

The example is different from the example of Fig. 39 in that the calculation section 460 gives feedback to the phase detection circuits 500-1 and 500-2 configuring the normal operation function section 11 and the temperature characteristic identification function section 12 such that both of output of integrating circuits 520-1 and 520-2 in the normal operation function section 11 and the temperature characteristic identification function section 12 correspond to each other, and other operation is exactly the same.

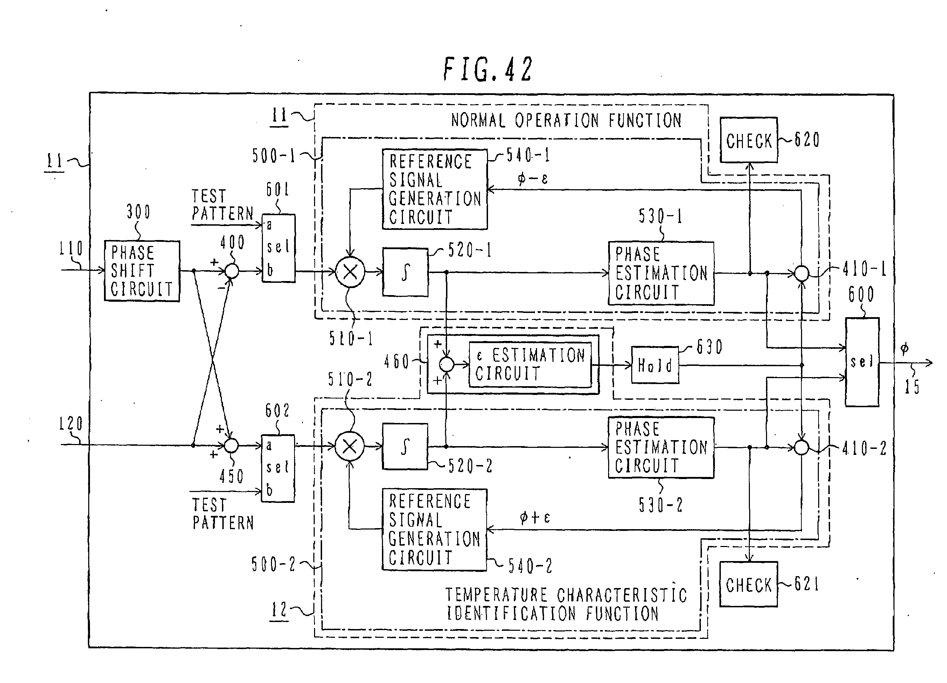

Accordingly, as in the example of Fig. 39, the phase detection circuits 500-1 and 500-2 generally perform convergent operation such that output of reference signal generation circuits 540-1 and 540-2 having phases $\phi+\varepsilon$ and $\phi-\varepsilon$ respectively correspond in phase to input signals having phases $\theta+\varepsilon$ and $\theta-\varepsilon$ respectively. Therefore, outputs $\phi$ of the phase estimation circuits 530-1 and 530-2 converge to $\theta$, that is, operate to detect phases of input signals after the signal delay characteristic $\varepsilon(\tau)$ has been corrected. Fig. 42 shows an example where a configuration of an embodiment of the invention is applied to the example of Fig. 41. Compared with the example of Fig. 17, the example is different only in the configurations of the temperature characteristic identification function section 12 and the normal operation function section 11 as previously described in Fig. 41, and other configurations and operation of the example are the same as in Fig. 17. Therefore, operation of the selectors in each mode is also as shown in Fig. 18.

**Claims**

1. A resolver/digital-converter, comprising;
   a normal operation function section (11) for calculating angle information based on a signal from a resolver,
   a temperature characteristic identification function section (12) for calculating a correction value for correcting a temperature characteristic of the angle information based on a signal from said resolver,
   a fault detection unit (622) for examining said normal operation function section or said temperature characteristic identification function section, and
   a holding function section (630) or holding the correction value,
   wherein when said normal operation function section is examined, the angle information is calculated using said temperature characteristic identification function section, and the calculated value is corrected by the correction value held in said holding function section.

2. The resolver/digital-converter according to claim 1, further comprising;
   a first temperature characteristic correction function section for correcting an estimated angle output from said normal operation function section based on the temperature characteristic identification value by said temperature characteristic identification function section, the value being held in said holding function section, and

a second temperature characteristic correction function section for correcting an estimated angle output from said temperature characteristic identification function section based on the temperature characteristic identification value by said temperature characteristic identification function section, the value being held in said holding function section.

**3.** The resolver/digital-converter according to claim 2,
wherein one of the outputs of said first temperature characteristic correction function section and said second temperature characteristic correction function section is selected as output of the angle information.

**4.** The resolver/digital-converter according to claim 1, further comprising;
a first test signal injection function section for injecting a test input into said normal operation function section, and
a second test signal injection function section for injecting a test input into said temperature characteristic identification function section.

**5.** The resolver/digital-converter according to claim 1, further comprising;
a first check function section for comparatively checking an expected value for the test input injected by said first test signal injection function section and output of said normal operation function section, and
a second check function section for comparatively checking an expected value for the test input injected by said second test signal injection function section and output of said temperature characteristic identification function section.

**6.** The resolver/digital-converter according to claim 1,
further comprising a function section for outputting a test result,
wherein in the case that when said first test signal injection function section injects the test input, said first check function section detects a fact that the expected value for the test input is inconsistent with the output of said normal operation function section, or
in the case that when said second test signal injection function section injects the test input, said second check function section detects a fact that the expected value for the test input is inconsistent with the output of said temperature characteristic identification function section, a signal showing an abnormal condition is outputted as the test result.

**7.** The resolver/digital-converter according to claim 6,
wherein in the test result, an alternating signal is outputted as a signal showing a normal condition, and a signal other than the alternating signal is outputted as a signal showing an abnormal condition.

**8.** The resolver/digital-converter according to claim 1,
wherein said normal operation function section or said temperature characteristic identification function section has a phase shift circuit for changing the phase of the first resolver signal, and an addition/subtraction function section for adding/subtracting the output of said phase shift circuit with respect to the second resolver signal, and
said first test signal injection function section and said second test signal injection function section exist in a stage subsequent to said phase shift circuit and said addition/subtraction function section.

**9.** The resolver/digital-converter according to claim 1,
wherein said normal operation function section or said temperature characteristic identification function section has a phase shift circuit for changing the phase of the first resolver signal, and an addition/subtraction function section for adding/subtracting the output of said phase shift circuit with respect to the second resolver signal,
said first test signal injection function section and said second test signal injection function section are provided in a stage subsequent to said phase shift circuit and said addition/subtraction function section, and
a third test signal injection function section for injecting a test signal into the first resolver signal, and a fourth test signal injection function section for injecting a test signal into the second resolver signal are provided in a stage previous to said phase shift circuit and said addition/subtraction function section.

**10.** The resolver/digital-converter according to claim 1,
wherein said normal operation function section and said temperature characteristic identification function section separately have a phase shift circuit for changing the phase of the first resolver signal, and an addition/subtraction function section for adding/subtracting the output of said phase shift circuit with respect to the second resolver signal, and
said first test signal injection function section and said second test signal injection function section exist in a stage

EP 1 826 906 A2

previous to said phase shift circuit and said addition/subtraction function section.

11. A resolver/digital-converter, which is inputted with first and second resolver signals from a resolver, and outputs angle information output corresponding to the inputted resolver signals, comprising
a first operation mode for outputting angle information which is corrected in temperature characteristic based on a latest temperature characteristic identification value, and
a second mode for carrying out examination of said normal operation function section or said temperature characteristic identification function section, and for outputting angle information having been corrected in temperature characteristic based on a temperature characteristic identification value being held.

12. The resolver/digital-converter according to claim 11, further comprising
a third mode for carrying out examination of said normal operation function section or said temperature characteristic identification function section, and for outputting an output signal of said normal operation function section or said temperature characteristic identification function section corresponding to a test signal inputted for the examination in place of the angle information.

13. The resolver/digital-converter according to one of claims 9, 11 and 12:
wherein test signals are injected by said first and second test signal injection function sections in said second operation mode, and
test signals are injected by said third and fourth test signal injection function sections in said third operation mode.

14. The resolver/digital-converter according to claim 11,
wherein start information for starting said second operation mode is inputted from the outside.

15. The resolver/digital-converter according to claim 11,
wherein information that permits the start information for starting said second operation mode is inputted from the outside.

16. The resolver/digital-converter according to claim 12,
wherein start information for starting said third operation mode is inputted from the outside.

17. The resolver/digital-converter according to claim 12,
wherein information that permits the start information for starting said third operation mode is inputted from the outside.

18. The resolver/digital-converter according to claim 11, further comprising a timer,
wherein the operation in said second operation mode is started by the timer, and the operation in said first operation mode is started after said second operation mode is finished.

19. The resolver/digital-converter according to claim 12, further comprising a power-on detection circuit,
wherein the operation in said third operation mode is started by said power-on detection circuit, and the operation in said first operation mode is started after the third operation mode is finished.

20. The resolver/digital-converter according to claim 1, further comprising
a function section inwhich outputs signals having different phases from each other as a first excitation signal corresponding to the first resolver signal of said resolver, and a second excitation signal corresponding to the second resolver signal of said resolver, and
detects the phases of the carrier waves of the first and second resolver signals.

21. The resolver/digital-converter according to claim 20,
wherein when the phases of the carrier waves of the first and second resolver signals deviate from a predetermined range, a signal indicating an abnormal condition is outputted as a test result.

22. A control system comprising a resolver, an exciting circuit, a motor, a resolver/digital-converter, and an inverter, in which said excitation circuit outputs an excitation signal to said resolver, said motor is connected to said resolver through a rotation shaft, said resolver/digital-converter receives a signal from said resolver, and outputs rotation angle information of said resolver and test result output, and said inverter drives said motor,
wherein said resolver/digital-converter is the resolver/digital-converter according to one of claim 1 or 11.

**23.** The control system according to claim 22, further comprising
a unit for braking the drive output from said inverter to said motor, and
when the test result output indicates an abnormal condition, the drive output from said inverter to said motor is broken by the braking unit.

**24.** The control system according to claim 22, further comprising
a power braking unit for braking the power to said inverter, and
when the test result output indicates an abnormal condition, the power to said inverter is broken by said power braking unit.

**25.** The control system according to claim 22, further comprising
a drive signal braking unit for braking a drive signal to said inverter, and
when the test result output indicates an abnormal condition, the drive signal to said inverter is broken by the drive signal braking unit.

**26.** The control system according to claim 22, further comprising
a plurality of the resolver/digital-converters, and
at least one of the plurality of said resolver/digital-converters is the resolver/digital-converter according to claim 1.

**27.** An electric power steering, comprising;
a control system according to claim 22,
a steering wheel,
a torque sensor, and
a steering mechanism,
wherein said motor is mechanically connected to said steering mechanism.

**28.** A resolver/digital-converter, comprising;
a normal operation function section for being inputted with first and second output signals of a resolver, and outputs angle information corresponding to the inputted resolver output signals,
a temperature characteristic identification function section for being inputted with the first and second output signals of said resolver, calculates angle information corresponding to the inputted resolver output signals, and outputs a correction value for correcting a temperature characteristic of output of said normal operation function section based on the relevant angle information and a reference signal,
a holding function section for holding the correction value,
a fault detection unit for inputting a test signal into said normal operation function section, and examines said normal operation function section based on an expected value of output corresponding to the relevant test signal, and output of said normal operation function section when the relevant test signal is inputted,
an input selector for selecting one of the output signal of said resolver and the test signal of said fault detection unit, and inputs it into said normal operation function section, and
an output selector for selecting one of the angle information outputted by said normal operation function section and the angle information calculated by said temperature characteristic identification function section, and outputs it to the outside,
wherein when said input selector selects the test signal, said output selector selects the angle information calculated by said temperature characteristic identification function section.

# FIG.1

EP 1 826 906 A2

# FIG.2

| mode | sel 602 | |
|------|---------|---|
| 0s | b | NORMAL OPARATION (ESTIMATING $\varepsilon(\tau)$ USING sin SIGNAL) |
| 0c | c | NORMAL OPARATION (ESTIMATING $\varepsilon(\tau)$ USING cos SIGNAL) |

# FIG.3A

# FIG.3B

# FIG.4

EP 1 826 906 A2

## FIG.5

| mode | sel 601 | sel 602 | Hold 630 | sel 600 | |
|---|---|---|---|---|---|
| 0 | b | a | THROUGH | * | NORMAL OPERATION |
| 1 | a | a | HOLD | b | NORMAL OPARATION FUNCTION TEST (ONLINE) |
| 2 | b | b | HOLD | a | TEMPERATURE CHARACTERISTIC IDENTIFICATION FUNCTION TEST (ONLINE) |
| 3 | a | * | HOLD | a | NORMAL OPARATION FUNCTION TEST (OFFLINE) |
| 4 | * | b | HOLD | b | TEMPERATURE CHARACTERISTIC IDENTIFICATION FUNCTION TEST (OFFLINE) |

EP 1 826 906 A2

# FIG.6

| case | TEST PATTERN | | EXPECTED VALUE $\phi$ ($^{\circ}$el.) |
|---|---|---|---|
| | sin SIGNAL | cos SIGNAL | |
| 1 | 0 | sin($\omega$t) | 0 |
| 2 | 0.707*sin($\omega$t) | 0.707*sin($\omega$t) | 45 |
| 3 | sin($\omega$t) | 0 | 90 |
| 4 | 0.707*sin($\omega$t) | −0.707*sin($\omega$t) | 135 |
| 5 | 0 | −sin($\omega$t) | 180 |
| 6 | −sin($\omega$t)/1.14142 | −0.707*sin($\omega$t) | 225 |
| 7 | −sin($\omega$t) | 0 | 270 |
| 8 | −0.707*sin($\omega$t) | 0.707*sin($\omega$t) | 315 |

# FIG.7

EP 1 826 906 A2

# FIG.8

| mode | sel 601 | sel 602 | Hold 630 | sel 600 | |
|------|---------|---------|----------|---------|--|
| 0s | b | b | · | a | NORMAL OPARATION (ESTIMATING $\varepsilon(\tau)$ USING sin SIGNAL) |
| 0c | b | c | THROUGH | a | NORMAL OPARATION (ESTIMATING $\varepsilon(\tau)$ USING cos SIGNAL) |
| 1 | a | a | HOLD | b | NORMAL OPARATION FUNCTION TEST (ONLINE) |
| 2 | b | d | HOLD | a | TEMPERATURE CHARACTERISTIC IDENTIFICATION FUNCTION TEST (ONLINE) |
| 3 | a | * | HOLD | a | NORMAL OPARATION FUNCTION TEST (OFFLINE) |
| 4 | * | d | HOLD | b | TEMPERATURE CHARACTERISTIC IDENTIFICATION FUNCTION TEST (OFFLINE) |

EP 1 826 906 A2

# FIG.9

EP 1 826 906 A2

# FIG.10

ONLINE TEST
EXECUTION/NON-EXECUTION

ONLINE TEST TIMER
START ENABLE

OFFLINE TEST
EXECUTION/NON-EXECUTION

OFFLINE TEST POWER-ON
START ENABLE

| FIELD 1 | FIELD 2 | FIELD 3 | FIELD 4 | FIELD 5 | FIELD 6 | FIELD 7 |

ONLINE TEST PERIOD    ONLINE TEST DURATION    OFFLINE TEST DURATION

EP 1 826 906 A2

# FIG.11

TIME →

| OFFLINE TEST | NORMAL OPERATION | ONLINE TEST | NORMAL | ONLINE TEST | NORMAL OPERATION | ----- |

INITIALIZATION

NORMAL PROCESSING

TEMPERATURE CHARACTERISTIC. CORRECTION

| DISABLE | REALTIME ○ | HOLD VALUE | REALTIME ○ | HOLD VALUE | REALTIME |

FINAL OUTPUT 15

| OFFLINE TEST OUTPUT | ANGLE OUTPUT φ |

POWER ON

NOT AFFECTED BY TEMPERATURE CHANGE

AFFECTED BY TEMPERATURE CHANGE

NOT AFFECTED BY TEMPERATURE CHANGE

AFFECTED BY TEMPERATURE CHANGE

NOT AFFECTED BY TEMPERATURE CHANGE

EP 1 826 906 A2

# FIG.12

TIME →

| Mode 5.6 | Mode 1/2 | Mode 3 | Mode 1/2 | Mode 3 | Mode 1/2 | ------ |

INITIALIZATION

NORMAL PROCESSING

TEMPERATURE CHARACTERISTIC CORRECTION

| DISABLE | REALTIME ○ | ▼ HOLD VALUE | REALTIME ○ | ▼ HOLD VALUE | REALTIME |

FINAL OUTPUT 15

| OFFLINE TEST OUTPUT | ANGLE OUTPUT φ |

▲ POWER ON

NOT AFFECTED BY TEMPERATURE CHANGE

NOT AFFECTED BY TEMPERATURE CHANGE

NOT AFFECTED BY TEMPERATURE CHANGE

AFFECTED BY TEMPERATURE CHANGE

AFFECTED BY TEMPERATURE CHANGE

EP 1 826 906 A2

# FIG.13

## FIG.14

| mode | sel 601 | sel 602 | sel 607 | sel 608 | Hold 630 | sel 600 | |
|------|---------|---------|---------|---------|----------|---------|---|
| 0s | b | b | b | b | THROUGH | a | NORMAL OPARATION (ESTIMATING $\varepsilon(\tau)$ USING sin SIGNAL) |
| 0c | b | c | b | b | THROUGH | a | NORMAL OPARATION (ESTIMATING $\varepsilon(\tau)$ USING cos SIGNAL) |
| 1 | a | a | b | b | HOLD | b | NORMAL OPARATION FUNCTION TEST (ONLINE) |
| 2 | b | d | b | b | HOLD | a | TEMPERATURE CHARACTERISTIC IDENTIFICATION FUNCTION TEST (ONLINE) |
| 3 | b | * | a | a | HOLD | a | NORMAL OPARATION FUNCTION TEST (OFFLINE) |
| 4 | * | c | a | a | HOLD | b | TEMPERATURE CHARACTERISTIC IDENTIFICATION FUNCTION TEST (OFFLINE) |

EP 1 826 906 A2

FIG.15

EP 1 826 906 A2

FIG.16

| mode | sel 603 | sel 604 | sel 605 | sel 606 | sel 604 | Hold 630 | sel 600 | |
|------|---------|---------|---------|---------|---------|----------|---------|---|
| 0 s | b | b | * | * | b | THROUGH | a | NORMAL OPARATION (ESTIMATING $\varepsilon(\tau)$ USING sin SIGNAL) |
| 0 c | b | b | * | * | c | THROUGH | a | NORMAL OPARATION (ESTIMATING $\varepsilon(\tau)$ USING cos SIGNAL) |
| 1 | a | a | b | b | a | HOLD | b | NORMAL OPARATION FUNCTION TEST (ONLINE) |
| 2 | b | b | a | a | a | HOLD | a | TEMPERATURE CHARACTERISTIC IDENTIFICATION FUNCTION TEST (ONLINE) |
| 3 | a | a | * | * | a | HOLD | a | NORMAL OPARATION FUNCTION TEST (OFFLINE) |
| 4 | * | * | a | a | a | HOLD | b | TEMPERATURE CHARACTERISTIC IDENTIFICATION FUNCTION TEST (OFFLINE) |

EP 1 826 906 A2

# FIG.17

EP 1 826 906 A2

# FIG.18

| mode | sel 601 | sel 602 | Hold 630 | sel 600 | |
|---|---|---|---|---|---|
| 0 | b | a | THROUGH | * | NORMAL OPERATION |
| 1 | a | a | HOLD | b | NORMAL OPARATION FUNCTION TEST (ONLINE) |
| 2 | b | b | HOLD | a | TEMPERATURE CHARACTERISTIC IDENTIFICATION FUNCTION TEST (ONLINE) |
| 3 | a | * | HOLD | b | NORMAL OPARATION FUNCTION TEST (OFFLINE) |
| 4 | * | b | HOLD | a | TEMPERATURE CHARACTERISTIC IDENTIFICATION FUNCTION TEST (OFFLINE) |

EP 1 826 906 A2

FIG.19

# FIG.20

| mode | sel 601 | sel 602 | sel 607 | sel 608 | Hold 630 | sel 600 | |
|------|---------|---------|---------|---------|----------|---------|---|
| 0 | b | a | b | b | THROUGH | * | NORMAL OPERATION |
| 1 | a | a | b | b | HOLD | b | NORMAL OPARATION FUNCTION TEST (ONLINE) |
| 2 | b | b | b | b | HOLD | a | TEMPERATURE CHARACTERISTIC IDENTIFICATION FUNCTION TEST (ONLINE) |
| 3 | b | * | a | * | HOLD | b | NORMAL OPARATION FUNCTION TEST (OFFLINE) |
| 4 | * | a | * | a | HOLD | a | TEMPERATURE CHARACTERISTIC IDENTIFICATION FUNCTION TEST (OFFLINE) |

EP 1 826 906 A2

FIG.21

EP 1 826 906 A2

## FIG.22

| mode | sel 603 | sel 604 | sel 605 | sel 606 | Hold 630 | sel 600 | |
|---|---|---|---|---|---|---|---|
| 0 | b | b | b | b | THROUGH | * | NORMAL OPERATION |
| 1 | a | a | b | b | HOLD | b | NORMAL OPARATION FUNCTION TEST (ONLINE) |
| 2 | b | b | a | a | HOLD | a | TEMPERATURE CHARACTERISTIC IDENTIFICATION FUNCTION TEST (ONLINE) |
| 3 | a | a | * | * | HOLD | b | NORMAL OPARATION FUNCTION TEST (OFFLINE) |
| 4 | * | * | a | a | HOLD | a | TEMPERATURE CHARACTERISTIC IDENTIFICATION FUNCTION TEST (OFFLINE) |

EP 1 826 906 A2

EP 1 826 906 A2

# FIG.23

# FIG.24

| mode | sel 602 | |
|---|---|---|
| 0s | b | NORMAL OPARATION (ESTIMATING $\varepsilon(\tau)$ USING sin SIGNAL) <br> PHASE-TO-PHASE SHORT CHECK |
| 0c | c | NORMAL OPARATION (ESTIMATING $\varepsilon(\tau)$ USING cos SIGNAL) <br> PHASE-TO-PHASE SHORT CHECK |

# FIG.25

0           $\alpha$           $2\pi$

RESOLVER OUTPUT SIGNAL 110      RESOLVER OUTPUT SIGNAL 120

$\varepsilon(\tau)$        $\varepsilon(\tau)+\alpha$

OUTPUT OF OPERATIONAL AMPLIFIER 400

FIG.26B

FIG.26A

# FIG.27

EP 1 826 906 A2

## FIG.28

| mode | sel 601 | sel 602 | Hold 630 | sel 600 | |
|---|---|---|---|---|---|
| 0 s | b | b | THROUGH | a | NORMAL OPARATION (ESTIMATING $\varepsilon(\tau)$ USING sin SIGNAL)<br><br>PHASE-TO-PHASE SHORT CHECK |
| 0 c | b | c | THROUGH | a | NORMAL OPARATION (ESTIMATING $\varepsilon(\tau)$ USING cos SIGNAL)<br><br>PHASE-TO-PHASE SHORT CHECK |
| 1 | a | a | HOLD | b | NORMAL OPARATION FUNCTION TEST (ONLINE) |
| 2 | b | d | HOLD | a | TEMPERATURE CHARACTERISTIC IDENTIFICATION FUNCTION TEST (ONLINE) |
| 3 | a | * | HOLD | a | NORMAL OPARATION FUNCTION TEST (OFFLINE) |
| 4 | * | d | HOLD | b | TEMPERATURE CHARACTERISTIC IDENTIFICATION FUNCTION TEST (OFFLINE) |

EP 1 826 906 A2

# FIG.29

EP 1 826 906 A2

## FIG.30

| mode | sel 601 | sel 602 | Hold 630 | sel 600 | |
|------|---------|---------|----------|---------|---|
| 0 | b | a | THROUGH | * | NORMAL OPERATION |
| 5 | b | b | HOLD | a | PHASE-TO-PHASE SHORT CHECK |
| 6 | b | c | HOLD | a | PHASE-TO-PHASE SHORT CHECK |
| 1 | a | a | HOLD | b | NORMAL OPARATION FUNCTION TEST (ONLINE) |
| 2 | b | b | HOLD | a | TEMPERATURE CHARACTERISTIC IDENTIFICATION FUNCTION TEST (ONLINE) |
| 3 | a | * | HOLD | b | NORMAL OPARATION FUNCTION TEST (OFFLINE) |
| 4 | * | b | HOLD | a | TEMPERATURE CHARACTERISTIC IDENTIFICATION FUNCTION TEST (OFFLINE) |

EP 1 826 906 A2

# FIG. 31

FIG.32

# FIG.33

EP 1 826 906 A2

# FIG.34

# FIG.35

TEST RESULT 657

TEST RESULT' 657'

ACK 658

# FIG. 36

# FIG. 37

# FIG. 38

# FIG. 39

EP 1 826 906 A2

# FIG.40

EP 1 826 906 A2

# FIG.41

EP 1 826 906 A2

# FIG.42

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000353957 A
- JP 2005348208 A
- JP 9126809 A
- JP 7131972 A
- JP 9133718 A
- JP 2005003530 A
- JP 2005207960 A
- JP 2005034208 A